(19) **Europäisches Patentamt / European Patent Office / Office européen des brevets**

(11) **EP 3 297 048 B1**

(12) **EUROPEAN PATENT SPECIFICATION**

(45) Date of publication and mention
of the grant of the patent:
**18.11.2020 Bulletin 2020/47**

(21) Application number: **16796246.3**

(22) Date of filing: **19.04.2016**

(51) Int Cl.:
*C22C 30/00* (2006.01)     *C22C 30/02* (2006.01)
*C22C 30/04* (2006.01)     *C22C 38/14* (2006.01)
*C22C 38/00* (2006.01)     *B22F 3/14* (2006.01)
*H01L 35/14* (2006.01)     *C22C 38/12* (2006.01)
*C22C 38/16* (2006.01)     *H01L 35/20* (2006.01)
*C22C 38/02* (2006.01)

(86) International application number:
**PCT/JP2016/062315**

(87) International publication number:
**WO 2016/185852 (24.11.2016 Gazette 2016/47)**

(54) **THERMOELECTRIC CONVERSION MATERIAL**

MATERIAL ZUR THERMOELEKTRISCHEN UMWANDLUNG

MATÉRIAU DE CONVERSION THERMOÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.05.2015 JP 2015099647**

(43) Date of publication of application:
**21.03.2018 Bulletin 2018/12**

(73) Proprietor: **Hitachi Metals, Ltd.**
**Tokyo 108-8224 (JP)**

(72) Inventors:
• **NISHIDE, Akinori**
  **Tokyo 100-8280 (JP)**
• **FUKATANI, Naoto**
  **Tokyo 100-8280 (JP)**
• **HAYAKAWA, Jun**
  **Tokyo 100-8280 (JP)**
• **YABUCHI, Shin**
  **Tokyo 100-8280 (JP)**
• **KUROSAKI, Yosuke**
  **Tokyo 100-8280 (JP)**

(74) Representative: **MERH-IP Matias Erny Reichl Hoffmann**
**Patentanwälte PartG mbB**
**Paul-Heyse-Strasse 29**
**80336 München (DE)**

(56) References cited:
**EP-A1- 2 854 189          WO-A1-2013/093967**
**WO-A1-2013/175571    JP-A- 2008 021 982**
**JP-A- 2010 226 034      JP-A- 2013 149 878**
**JP-A- 2015 005 653        US-A1- 2012 032 105**
**US-A1- 2014 345 663**

• **RAGHAVAN V: "Fe-Si-Ti (Iron-Silicon-Titanium)", JOURNAL OF PHASE EQUILIBRIA AND DIFFUSION, SPRINGER NEW YORK LLC, US, vol. 30, no. 4, 1 January 2009 (2009-01-01), pages 393-396, XP002738884, ISSN: 1547-7037, DOI: 10.1007/S11669-009-9555-5**
• **TANJA GRAF ET AL: "Simple rules for the understanding of Heusler compounds", PROGRESS IN SOLID STATE CHEMISTRY, vol. 39, no. 1, 31 May 2011 (2011-05-31), pages 1-50, XP028384439, ISSN: 0079-6786, DOI: 10.1016/J.PROGSOLIDSTCHEM.2011.02.001 [retrieved on 2011-03-05]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

<u>TECHNICAL FIELD</u>

The present invention relates to a thermoelectric conversion material.

<u>BACKGROUND ART</u>

Recently, there has been an increasing international concern on the issue of reducing $CO_2$ which is a substance responsible for the global wanning phenomenon. Continuous progress is being made in technical innovations for shifting from resource energy discharging large amounts of $CO_2$, to next generation energy, for example, reusing natural energy and thermal energy. Candidates for next generation energy techniques include a technique utilizing natural energy such as sunlight and wind power, and a reusable technique for utilizing losses of primary energy such as heat and vibration discharged by use of resource energy.

Though conventional resource energy is centralized energy mainly in the form of large-scale power generation facilities, next generation energy is featured by an uneven distribution of both natural energy and reusable energy. In current energy utilization, the energy discharged without being used amounts to approximately 60% of primary energy and mainly in the form of exhaust heat. Further, among exhaust heat, the exhaust heat at 200°C or less amounts to 70%. Therefore, what is needed besides a technique of increasing the proportion of next generation energy among primary energy is an improved energy reutilization technique and in particular, an improved power conversion technique for exhaust heat energy at 200°C or less.

Since exhaust heat is generated in various situations, re-utilizing exhaust heat energy requires a power generation system with a high degree of universality in installation formats. The powerful candidate technique includes a thermoelectric conversion technique.

A main part of the thermoelectric conversion technique is a thermoelectric conversion module. The thermoelectric conversion module is disposed closer to a heat source, and a temperature difference in the thermoelectric conversion module results in the generation of electricity. The thermoelectric conversion module has a structure in which an n-type thermoelectric conversion material producing electromotive force from the high temperature side to the low temperature side in temperature gradient and a p-type thermoelectric conversion material producing electromotive force in a direction opposite to that of the n-type thermoelectric conversion material are alternately arranged.

International Publication No. WO 2013/093967 (Patent Document 1) discloses a technique of providing a pair of Heusler alloys made of an n-type Heusler alloy and a p-type Heusler alloy connected with an electrode in a thermoelectric conversion element.

Maximum output P of the thermoelectric conversion module is determined by a product of heat flow flowing into the thermoelectric conversion module and conversion efficiency η of the thermoelectric conversion material. The heat flow depends on a module structure suitable for the thermoelectric conversion material. Further, the conversion efficiency η depends on a dimensionless figure of merit ZT of the thermoelectric conversion material. Note that the "dimensionless figure of merit" is also simply referred to as "figure of merit."

The figure of merit ZT is represented by a mathematical formula (Mathematical Formula 5) below:

[Mathematical Formula 5]

$$ZT = \frac{S^2}{\kappa\rho}T \qquad \text{... (Mathematical Formula 5)}$$

Here, S is a Seebeck coefficient, ρ is an electric resistivity, κ is a thermal conductivity, and T is a temperature. Therefore, in order to enhance the maximum output P of the thermoelectric conversion module, it is desirable to increase the Seebeck coefficient S of the thermoelectric conversion material, to decrease the electric resistivity ρ, and to decrease the thermal conductivity κ.

Subsequently, a composition of the thermoelectric conversion material will be mentioned.

The thermoelectric conversion material is mainly classified into a metal-based thermoelectric conversion material and a compound-based, i.e., a semiconductor-based thermoelectric conversion material and an oxide-based thermoelectric conversion material. Among the thermoelectric conversion materials, the thermoelectric conversion material having temperature characteristics adaptable for exhaust heat recovery at 200°C or less is typically, for example, an $Fe_2VAl$-based full-Heusler alloy or a Bi-Te-based semiconductor.

The $Fe_2VAl$-based full-Heusler alloy is a metal-based thermoelectric conversion material, and the Bi-Te-based semiconductor is a compound-based thermoelectric conversion material. The two materials in themselves can become structural materials and are suitable for the thermoelectric conversion module used for exhaust heat recovery in a power plant, a factory, or an automobile. However, there is a problem that the Bi-Te-based semiconductor has high toxicity of Te and is expensive. Accordingly, the $Fe_2VAl$-based full-Heusler alloy is suitable for use of the exhaust heat recovery described above, compared to the Bi-Te-based semiconductor.

Japanese Patent Application Laid-Open Publication No. 2013-102002 (Patent Document 2) discloses a technique in which a Heusler type iron-based thermoelectric material is configured to include an $Fe_2VAl$ group Heusler compound and a mass of C contained in a base material of the Heusler compound as inevitable impurities is controlled to be 0.15 mass% or less and a mass of C + O + N is controlled to be 0.30 mass% or less.

## RELATED ART DOCUMENTS

## PATENT DOCUMENTS

Patent Document 1: International Publication No. WO 2013/093967

Patent Document 2: Japanese Patent Application Laid-Open Publication No. 2013-102002

In JP 2013 149878 A a thermoelectric conversion material is described. The thermoelectric conversion material has a band structure near Fermi energy of at least one of a valence band and a conduction band of a semiconductor.

Raghavan V.: "Fe-Si-Ti (Iron-Silicon-Titanium)", Journal of Phase Equilibria and Diffusion, Springer New York LLC, US, vol. 30, no. 4, 1 January 2009 (2009-01-01), pages 393-396 (ISSN: 1547-7037) relates to a review of a ternary system.

In EP 2 854 189 A1 a thermoelectric conversion module with low toxicity is described. Said module exhibits conversion efficiency equivalent to that of BiTe. The conversion module employs a full Heusler alloy as the material for forming the P-type thermoelectric conversion unit and the N-type thermalelectric conversion unit.

In US 2014/345663 A1 a thermoelectric device and a thermoelectric module are described. The thermoelectric device includes a Heusler alloy material and a pair of electrodes that take out electromotive force according to a temperature gradient caused in the Heusler alloy material.

In JP 2008 021982 A a thermoelectric material and a method for manufacturing it is described.

## SUMMARY OF THE INVENTION

## PROBLEMS TO BE SOLVED BY THE INVENTION

As described above, the output of the thermoelectric conversion module including the thermoelectric conversion material depends on the figure of merit ZT of the thermoelectric conversion material. However, the figure of merit ZT of a thermoelectric conversion material made of a bulk material in a practical form, as a thermoelectric conversion material made of $Fe_2VAl$-based full-Heusler alloy, is substantially 0.1, and the value indicates that the thermoelectric conversion material made of the bulk material may not have sufficient durability to withstand practical use.

An object of the present invention is to provide a thermoelectric conversion material capable of enhancing the figure of merit ZT in the thermoelectric conversion material made of full-Heusler alloy.

The above-described and other objects and novel features of the present invention will become apparent from the description of the present specification and the accompanied drawings.

## MEANS FOR SOLVING THE PROBLEMS

The typical ones of the inventions disclosed in the present application will be briefly described as follows. To solve the problems the features of the independent claims are sugested.

## EFFECTS OF THE INVENTION

According to the present invention, it is possible to enhance the figure of merit ZT of the thermoelectric conversion material made of full-Heusler alloy.

## BRIEF DESCRIPTIONS OF THE DRAWINGS

FIG. 1 is a graph illustrating a relation of a Seebeck coefficient, a thermal conductivity, and an electric resistivity with an average crystal grain size;

FIG. 2 is a graph illustrating a relation of a figure of merit, an output factor, and a thermal conductivity with the average crystal grain size;

FIG. 3 is a diagram showing an electronic state of a full-Heusler alloy based on the first-principles calculation;

FIG. 4 is a diagram showing an electronic state of a full-Heusler alloy based on the first-principles calculation;

FIG. 5 is a graph illustrating a relation between a calculated Seebeck coefficient and an average valence electron number per atom;

FIG. 6 is a graph illustrating the relation between the calculated Seebeck coefficient and the average valence electron number per atom;

FIG. 7 is a graph illustrating the relation between the calculated Seebeck coefficient and the average valence electron number per atom;

FIG. 8 is a graph illustrating the relation between the calculated Seebeck coefficient and the average valence electron number per atom;

FIG. 9 is a graph illustrating the relation between the calculated Seebeck coefficient and the average valence electron number per atom;

FIG. 10 is a graph illustrating the relation between the calculated Seebeck coefficient and the average valence electron number per atom;

FIG. 11 is a graph illustrating the relation between the calculated Seebeck coefficient and the average valence electron number per atom;

FIG. 12 is a graph illustrating a relation between a calculated Seebeck coefficient and a substitution amount;

FIG. 13 is a graph illustrating the relation between the calculated Seebeck coefficient and the substitution amount;

FIG. 14 is a graph illustrating the relation between the calculated Seebeck coefficient and the substitution amount;

FIG. 15 is a graph illustrating the relation between the calculated Seebeck coefficient and the substitution amount;

FIG. 16 is a graph illustrating the relation between the calculated Seebeck coefficient and the substitution amount;

FIG. 17 is a graph illustrating the relation between the calculated Seebeck coefficient and the substitution amount;

FIG. 18 is a ternary phase diagram of Fe-Ti-Si;

FIG. 19 is a ternary phase diagram of Fe-Ti-Si;

FIG. 20 is a graph illustrating a relation between a Seebeck coefficient and an average valence electron number per atom;

FIG. 21 is a view illustrating a configuration of a thermoelectric conversion module obtained by use of a thermoelectric conversion material of an embodiment;

FIG. 22 is a view illustrating the configuration of the thermoelectric conversion module obtained by use of the thermoelectric conversion material of the embodiment;

FIG. 23 is a graph illustrating a relation between the Seebeck coefficient and the average crystal grain size;

FIG. 24 is a graph illustrating a relation between the electric resistivity and the average crystal grain size;

FIG. 25 is a graph illustrating a relation between the output factor and the average crystal grain size;

FIG. 26 is a graph illustrating a relation between the thermal conductivity and the average crystal grain size;

FIG. 27 is a graph illustrating a relation between the figure of merit and the average crystal grain size;

FIG. 28 is a graph illustrating a relation between the Seebeck coefficient and a Cu substitution amount; and

FIG. 29 is a graph illustrating a relation between the figure of merit and a V substitution amount.

## DETAILED DESCRIPTION OF PREFERRED EMBODIMENT

In an embodiment described below, the invention will be described in a plurality of sections or embodiments when required as a matter of convenience. However, these sections or embodiments are not irrelevant to each other unless otherwise stated, and the one relates to the entire or a part of the other as a modification example, details, or a supplementary explanation thereof.

Also, in the embodiment described below, when referring to the number of elements (including number of pieces, values, amount, range, and the like), the number of the elements is not limited to a specific number unless otherwise stated or except the case where the number is apparently limited to a specific number in principle. The number larger or smaller than the specific number is also applicable.

Further, in the embodiment described below, it goes without saying that the components (including element steps) are not always indispensable unless otherwise stated or except the case where the components are apparently indispensable in principle. Similarly, in the embodiment described below, when the shape of the components, positional relation thereof, and the like are mentioned, the substantially approximate and similar shapes and the like are included therein unless otherwise stated or except the case where it is conceivable that they are apparently excluded in principle. The same goes for the numerical value and the range described above.

Hereinafter, an embodiment of the present invention will be described in detail with reference to the accompanying drawings. Note that components having the same function are denoted by the same reference characters throughout the drawings for describing the embodiment, and the repetitive description thereof is omitted. In addition, the description of the same or similar portions is not repeated in principle unless particularly required in the following embodiment.

In the case where a range is indicated as A to B in the following embodiment, it is assumed to be A or more and B or less except for the cases where it is clearly indicated in particular.

(Embodiment)

<Control of Average Valence Electron Number Per Atom (Valence Electron Concentration: VEC)>

When synthesizing an $Fe_2TiSi$-based full-Heusler alloy or an $Fe_2TiSn$-based full-Heusler alloy (hereinafter referred to as "$Fe_2TiA$-based full-Heusler alloy"), an appropriate additive is added, in other words, any of Fe, Ti, and A is substituted by an appropriate element, and an average valence electron number per atom VEC is controlled such that $\Delta VEC$ to be mentioned below satisfies a relation $0 < |\Delta VEC| \leq 0.2$ or $0.2 < |\Delta VEC| \leq 0.3$. It has been found that, as a result of this process, the $Fe_2TiA$-based full-Heusler alloy to be synthesized exhibits a high figure of merit.

Hereinafter, this will be described in detail.

First, the average valence electron number per atom VEC (hereinafter sometimes simply referred to as "VEC") will be described.

VEC is an average value of electron numbers in the outermost shell of an atom and also a value obtained by dividing a total valence electron number Z of a compound by an atomic number a in a unit cell.

For example, in the case of $Fe_2TiSi$, iron (Fe) has a valence electron number of 8, titanium (Ti) has a valence electron number of 4, and silicon (Si) has a valence electron number of 4. Further, in the case of $Fe_2TiSi$, the atomic number of iron (Fe) in a unit cell is 2, the atomic number of titanium (Ti) in the unit cell is 1, and the atomic number of silicon (Si) in the unit cell is 1. Thus, the total valence electron number Z in $Fe_2VAl$ is calculated as follows: $Z = 8 \times 2 + 4 \times 1 + 4 \times 1 = 24$. The atomic number a in the unit cell is calculated as follows: $a = 2 + 1 + 1$. The average valence electron number per atom VEC is calculated as follows: $VEC = Z/a = 6$.

VEC is controlled by a substitution element.

Subsequently, $\Delta VEC$ of the present invention will be described.

The $\Delta VEC$ specified by the present invention is a difference between VEC in a composition in which a substitution element is not used and VEC in a composition in which a substitution element is used.

In the following paragraph, definition of $\Delta VEC$ will be described more in detail.

A thermoelectric conversion material made of p-type or n-type full-Heusler alloy is represented by a composition formula (Chemical Formula 1) below:

$$(Fe_{1-x}M1_x)_{2+\sigma}(Ti_{1-y}M2_y)_{1+\varphi}(A_{1-z}M3_z)_{1+\omega} \dots \qquad \text{(Chemical Formula 1)}$$

In the composition formula (Chemical Formula 1), A is at least one element selected from a group including Si and Sn. Further, M1 and M2 are at least one element selected from a group including Cu, Nb, V, Al, Ta, Cr, Mo, W, Hf, Ge, Ga, In, P, B, Bi, Zr, Mn, and Mg. Further, in the composition formula (Chemical Formula 1), M3 is at least one element selected from a group including Cu, Nb, V, Al, Ta, Cr, Mo, W, Hf, Ge, Ga, In, P, B, Bi, Zr, Mn, Mg, and Sn. In other words, it is assumed that a part of Fe is substituted by M1, a part of Ti is substituted by M2, and a part of A is substituted by M3 in the composition formula (Chemical Formula 1).

When $\sigma$, $\varphi$, and $\omega$ satisfy a relation $\sigma + \varphi + \omega = 0$ and x, y, and z satisfy relations $x = 0$, $y = 0$, and $z = 0$, respectively, contents of Fe, Ti, and A in the alloy represented by the composition formula (Chemical Formula 1) are u at%, v at%, and w at%, respectively, and the composition of the alloy in a ternary phase diagram of Fe-Ti-A is represented by a point (u, v, w), where a relation $u + v + w = 100$ is satisfied.

At this time, $\sigma$ is represented by a mathematical formula (Mathematical Formula 6) below, $\varphi$ is represented by a mathematical formula (Mathematical Formula 7) below, and $\omega$ is represented by a mathematical formula (Mathematical Formula 8) below:

$$\sigma = (u - 50)/25 \dots \quad \text{(Mathematical Formula 6)}$$

$$\varphi = (v - 25)/25 \dots \quad \text{(Mathematical Formula 7)}$$

$$\omega = (w - 25)/25 \ ... \quad \text{(Mathematical Formula 8)}$$

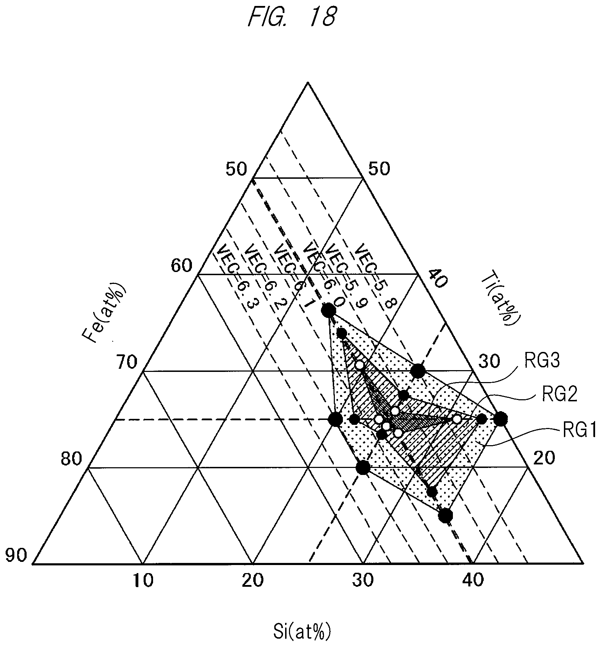

In the ternary phase diagram, for example, as illustrated in FIG 18, the point (u, v, w) is in a region RG1 inside a hexagon having points (50, 37, 13), (45, 30, 25), (39.5, 25, 35.5), (50, 14, 36), (54, 21, 25), and (55.5, 25, 19.5) as apexes (the region surrounded by the hexagon).

Here, a valence electron number of M1 is m1, a valence electron number of M2 is m2, and a valence electron number of M3 is m3. At this time, the average valence electron number per atom VEC in the full-Heusler alloy represented by the composition formula (Chemical Formula 1) is represented by a mathematical formula (Mathematical Formula 1) below as a function of $\sigma$, x, $\varphi$, y, $\omega$, and z:

$$\text{VEC}(\sigma, x, \varphi, y, \omega, z) = [\{8 \times (1 - x) + m1 \times x\} \times (2 + \sigma) + \{4 \times (1 - y) + m2 \times y\} \times (1 + \varphi) + \{4 \times (1 - z) + m3 \times z\} \times (1 + \omega)]/4 \ ... \quad \text{(Mathematical Formula 1)}$$

Here, when x, y, and z satisfy the relations x = 0, y = 0, and z = 0, respectively, relative to the average valence electron number per atom VEC ($\sigma$, 0, $\varphi$, 0, $\omega$, 0) in the alloy represented by the composition formula (Chemical Formula 1), the $\Delta$VEC which is an amount of change of the average valence electron number per atom VEC ($\sigma$, x, $\varphi$, y, $\omega$, z) is represented by a mathematical formula (Mathematical Formula 2) below:

$$\Delta\text{VEC} = \text{VEC}(\sigma, x, \varphi, y, \omega, z) - \text{VEC}(\sigma, 0, \varphi, 0, \omega, 0) \ ... \quad \text{(Mathematical Formula 2)}$$

x, y, and z are defined such that the $\Delta$VEC satisfies the relation $0 < |\Delta\text{VEC}| \leq 0.2$ or $0.2 < |\Delta\text{VEC}| \leq 0.3$, whereby the VEC is in a preferable range and a thermoelectric conversion material excellent in figure of merit ZT is obtained.

Further, the thermoelectric conversion material made of p-type or n-type full-Heusler alloy is represented by a composition formula (Chemical Formula 2) below:

$$(\text{Fe}_{1-x}\text{Cu}_x)_{2+\varphi}(\text{Ti}_{1-y}\text{V}_y)_{1+\varphi}\text{A}_{1+\omega} \ ... \quad \text{(Chemical Formula 2)}$$

In the composition formula (Chemical Formula 2), A is at least one element selected from the group including Si and Sn.

When $\sigma$, $\varphi$, and $\omega$ satisfy the relation $\sigma + \varphi + \omega = 0$ and x and y satisfy the relations x = 0 and y = 0, respectively, the contents of Fe, Ti, and A in the alloy represented by the composition formula (Chemical Formula 2) are u at%, v at%, and w at%, respectively, and the composition of the alloy in the ternary phase diagram of Fe-Ti-A is represented by the point (u, v, w).

At this time, the point (u, v, w) is located in the hexagon having the points (50, 37,13), (45, 30, 25), (39.5, 25, 35.5), (50, 14, 36), (54, 21, 25), and (55.5, 25, 19.5) as the apexes in the ternary phase diagram.

Further, at this time, the average valence electron number per atom VEC in the full-Heusler alloy represented by the composition formula (Chemical Formula 2) is represented by a mathematical formula (Mathematical Formula 3) below as the function of $\sigma$, $\varphi$, and $\omega$:

$$\text{VEC}(\sigma, x, \varphi, y, \omega) = [\{8 \times (1 - x) + 11 \times x\} \times (2 + \sigma) + \{4 \times (1 - y) + 5 \times y\} \times (1 + \varphi) + 4 \times (1 + \omega)]/4 \ ... \quad \text{(Mathematical Formula 3)}$$

Here, when x and y satisfy the relations x = 0 and y = 0, respectively, relative to the average valence electron number per atom VEC ($\sigma$, 0, $\varphi$, 0, $\omega$) in the alloy represented by the composition formula (Chemical Formula 2), the $\Delta$VEC which is an amount of change of the average valence electron number per atom VEC ($\sigma$, x, $\varphi$, y, $\omega$) is represented by a mathematical formula (Mathematical Formula 4) below:

$$\Delta\text{VEC} = \text{VEC}(\sigma, x, \varphi, y, \omega) - \text{VEC}(\sigma, 0, \varphi, 0, \omega)$$

$$... \quad \text{(Mathematical Formula 4)}$$

x, y, and z are defined such that the $\Delta$VEC satisfies the relation $0 < |\Delta\text{VEC}| \leq 0.2$ or $0.2 < |\Delta\text{VEC}| \leq 0.3$, whereby the VEC is in a preferable range and a thermoelectric conversion material excellent in figure of merit ZT is obtained.

When the relation $0 < |\Delta\text{VEC}| \leq 0.2$ or $0.2 < |\Delta\text{VEC}| \leq 0.3$ is satisfied, the VEC is in a preferable range. Accordingly, the absolute value of the Seebeck coefficient S becomes maximum when the full-Heusler alloy is the p-type. Also, the absolute value of the Seebeck coefficient S becomes maximum when the full-Heusler alloy is the n-type.

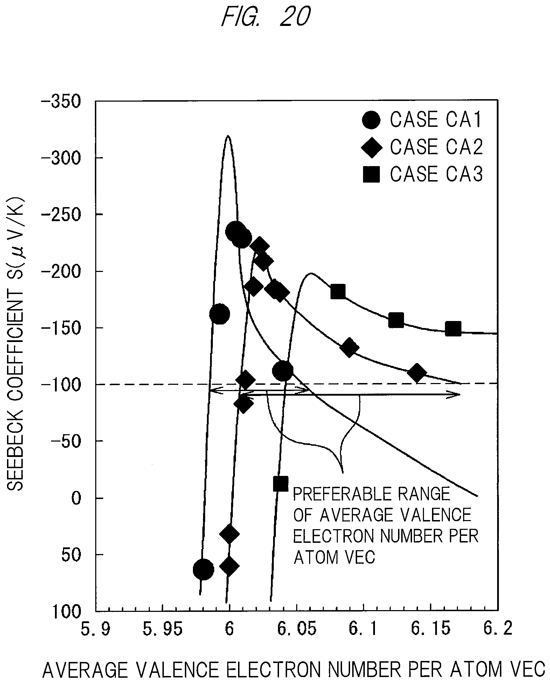

In order to allow the VEC to be in a preferable range, in the composition of the composition formula (Chemical Formula 1), each of the elements M1, M2, and M3 is added, in the composition of the composition formula (Chemical Formula 2), Cu and V are added, and a combination of x, y, and z or a combination of x and y may be selected such that the relation $0 < |\Delta VEC| \leq 0.2$ or $0.2 < |\Delta VEC| \leq 0.3$ is satisfied. Note that, as described with reference to FIG 20 below, when the $\Delta VEC$ satisfies the relation $0 < |\Delta VEC| \leq 0.05$, the Seebeck coefficient S becomes 150 $\mu$V/K or more, which is more preferred.

Hereinafter, the principle of the thermoelectric conversion characteristics of the thermoelectric conversion material made of full-Heusler alloy will be described.

A full-Heusler alloy with $L2_1$-type crystal structure represented by $E1_2E2E3$ has an electronic state, so-called pseudo gap. In order to describe how this pseudo gap is related to the thermoelectric conversion characteristics, a relation between the thermoelectric conversion characteristics of the thermoelectric conversion material and the electronic state will be described.

The thermoelectric conversion characteristics of the thermoelectric conversion material is evaluated by use of the figure of merit ZT. As described above, the figure of merit ZT is represented by the mathematical formula (Mathematical Formula 5). According to the mathematical formula (Mathematical Formula 5), as the Seebeck coefficient S is larger and the electric resistivity $\rho$ and the thermal conductivity $\kappa$ are smaller, the figure of merit ZT becomes larger.

Meanwhile, the Seebeck coefficient S and the electric resistivity $\rho$ are physical amounts determined by the electronic state of the substance contained in the thermoelectric conversion material. The Seebeck coefficient S has a relation represented by a mathematical formula (Mathematical Formula 9) below.

[Mathematical Formula 9]

$$S \propto \frac{1}{N(E_F)} \left( \frac{\partial N(E)}{\partial E} \right)_{E \sim EF} \qquad \text{... (Mathematical Formula 9)}$$

Here, E is a bond energy, and N is density of states.

According to the mathematical formula (Mathematical Formula 9), the Seebeck coefficient S is inversely proportional to the absolute value of the density of states N at the Fermi level and proportional to the energy gradient. Therefore, it is found that a substance which has a low density of states of the Fermi level and in which a rise of the density of states changes rapidly along with a change of energy near the Fermi level has a high Seebeck coefficient S.

Meanwhile, the electric resistivity $\rho$ is represented by a mathematical formula (Mathematical Formula 10) below.

[Mathematical Formula 10]

$$\frac{1}{\rho} \propto \lambda_F v_F N(E_F) \qquad \text{... (Mathematical Formula 10)}$$

Here, $\lambda_F$ is a mean free path of electrons at the Fermi level, and $v_F$ is a speed of electrons at the Fermi level.

According to the mathematical formula (Mathematical Formula 10), since the electric resistivity $\rho$ is inversely proportional to the density of states N, the electric resistivity $\rho$ decreases when the Fermi level is located at an energy position where the absolute value of density of states N is large.

Here, it is back to the pseudo gap electronic state. A band structure of the pseudo gap is an electronic state where the density of states near the Fermi level is extremely reduced. Further, regarding the characteristics of the band structure of the full-Heusler alloy with $L2_1$-type crystal structure represented by $E1_2E2E3$, the alloy behaves like a rigid band model, that is, when a composition ratio of the compound is changed, the band structure does not change largely and only the energy position of the Fermi level changes. Therefore, in the full-Heusler alloy, the density of states is steeply changed by modulating the composition or by modulating the composition so as to be in a state where electrons or holes are doped, and the Fermi level is controlled to be located at the energy position where the absolute value of the density of states is optimized. Thus, a relation between the Seebeck coefficient S and the electric resistivity $\rho$ can be optimized. The composition to be modulated can be considered based on the average valence electron number per atom VEC.

When the composition of the full-Heusler alloy is modulated, the value of the average valence electron number per atom VEC increases or decreases compared to a case in which the composition of the full-Heusler alloy is not modulated. The value of the average valence electron number per atom VEC increases or decreases, which is equivalent to the fact that electrons or holes are doped in the rigid band model described above. Accordingly, the value and polarity of the Seebeck coefficient S can be changed by controlling the average valence electron number per atom VEC.

Specifically, when the average valence electron number per atom VEC is less than 6, holes are doped to the full-Heusler alloy, thereby converting the full-Heusler alloy to the p-type thermoelectric conversion material. Meanwhile, when the average valence electron number per atom VEC is 6 or more, electrons are doped to the full-Heusler alloy, thereby converting the full-Heusler alloy to the n-type thermoelectric conversion material. Further, when the average valence electron number per atom VEC is continuously changed at around 6, the absolute value of the Seebeck coefficient S has a maximum value in each region where the average valence electron number per atom VEC is less than 6 and 6 or more, i.e., each region of the p-type and the-n type.

Hence, the full-Heusler alloy with $L2_1$-type crystal structure represented by E1$_2$E2E3 can be converted to the p-type thermoelectric conversion material and can be converted to the n-type thermoelectric conversion material. The thermoelectric conversion characteristics of the full-Heusler alloy with $L2_1$-type crystal structure represented by E1$_2$E2E3 are closely related to the energy position of the energy level which causes a steep change of the density of states. Therefore, the average valence electron number per atom VEC is controlled by modulating the composition or adding an element, thereby further improving the thermoelectric conversion characteristics of the thermoelectric conversion material made of full-Heusler alloy with $L2_1$-type crystal structure represented by E1$_2$E2E3.

FIG 20 is a graph illustrating a relation between the Seebeck coefficient S and the average valence electron number per atom VEC. In FIG 20, the Seebeck coefficient S of each composition in which a content of each of Fe, Ti, and A (i.e., a composition ratio of Fe, Ti, and A in the Fe$_2$TiA-based Full Heusler alloy) is fixed and then the VEC is adjusted, for example, by substituting a part of Ti with V is determined by the first-principles calculation.

Three types of data illustrated in FIG 20 show a case where the content of Fe is less than 50 at% (Case CA1), a case where the content of Fe is 50 at% (Case CA2), and a case where the content of Fe is greater than 50 at% (Case CA3). Specifically, the content of Fe is 49.5 at% in Case CA1, and the content of Fe is 51 at% in Case CA3.

In the composition formula (Chemical Formula 1), the average valence electron number per atom VEC at the relation x = y = z = 0 is defined as a central value of the average valence electron number per atom VEC. At this time, as illustrated in FIG 20, the average valence electron number per atom VEC is increased from the cental value of the average valence electron number per atom VEC to a positive side, whereby the absolute value of the Seebeck coefficient S once rapidly increases and reaches the maximum, and then, gradually decreases. As for a range in which the absolute value of the Seebeck coefficient S becomes 100 $\mu$V/K or more, as shown as a preferable range of the average valence electron number per atom VEC in FIG 20, for example, when the content of Fe is less than 50%, the average valence electron number per atom VEC is in a range from 5.98 to 6.06 with a range width of 0.08, and when the content of Fe is 50%, the average valence electron number per atom VEC is in a range from 6.01 to 6.17 with a range width of 0.16.

These results are consistent with the fact that, even when the content of Fe is decreased or increased from 50 at%, the range of the $\Delta$VEC in which the absolute value of the Seebeck coefficient S becomes 100 $\mu$V/K or more satisfies the relation $0 < |\Delta VEC| \leq 0.2$ or $0.2 < |\Delta VEC| \leq 0.3$, thereby enhancing the Seebeck coefficient S. More preferably, the range of the $\Delta$VEC in which the absolute value of the Seebeck coefficient S becomes 150 $\mu$V/K or more satisfies the relation $0 < |\Delta VEC| \leq 0.05$.

Note that, when Cu and V are used as the elements for controlling the VEC, for example, in order to obtain the thermoelectric conversion material made of p-type or n-type full-Heusler alloy having higher characteristics in the range satisfying the $\Delta$VEC in the full-Heusler alloy containing Fe, Ti, and A as main components, the content of Cu is greater than 0 at% and 1.75 at% or less, and the content of V is 1.0 at% or more and 4.2 at% or less. The content of Cu is more preferably 0.5 at% or more and 1.6 at% or less. The content of V is more preferably 2.2 at% or more and 3.2 at% or less.

<Composition of Fe$_2$TiA-Based Full-Heusler Alloy>

The reason that the Fe$_2$TiA-based full-Heusler alloy used in the present embodiment has a high Seebeck coefficient S will be described.

A characteristic band structure called "flat band" is present in a pseudo gap structure to determine the thermoelectric conversion characteristics of the full-Heusler alloy. The flat band mainly determines the thermoelectric conversion material. Therefore, it is possible to provide a novel thermoelectric conversion material with enhanced thermoelectric conversion characteristics by controlling the flat band to an appropriate state.

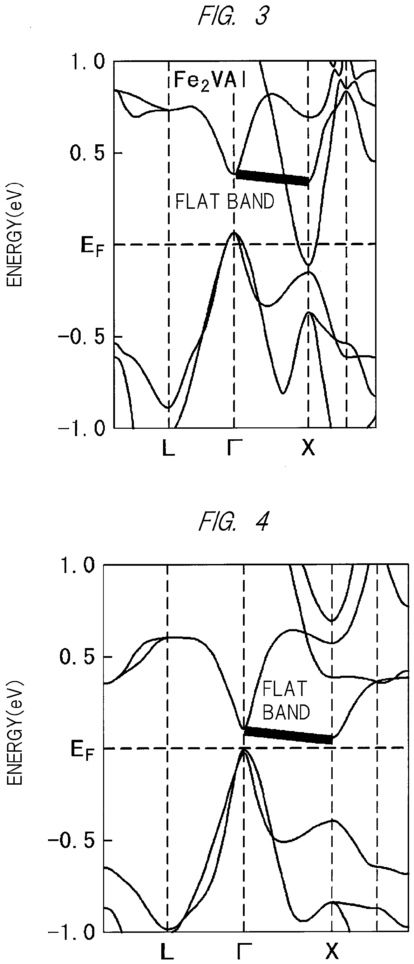

FIG 3 is a diagram showing an electronic state of a full-Heusler alloy based on the first-principles calculation, and FIG 4 is a diagram showing an electronic state of a full-Heusler alloy based on the first-principles calculation. FIG 3 shows the electronic state of the full-Heusler alloy represented by the composition formula Fe$_2$VAl, and FIG. 4 shows the electronic state of the full-Heusler alloy represented by the composition formula Fe$_2$TiSi.

As illustrated in FIGs. 3 and 4, the flat band of the full-Heusler alloy represented by the composition formula Fe$_2$TiSi is close to a Fermi level $E_F$, compared to that of the full-Heusler alloy represented by the composition formula Fe$_2$VAl. As a result, it is possible to steeply change the density of states near the Fermi level. Thus, the thermoelectric conversion characteristics (particularly the Seebeck coefficient S) are enhanced. Further, the full-Heusler alloy represented by the composition formula Fe$_2$TiSi is advantageous in that a pseudo gap value thereof is smaller than that of the full-Heusler alloy represented by the composition formula $Fe_2VAl$, whereby the electric resistivity $\rho$ does not increase.

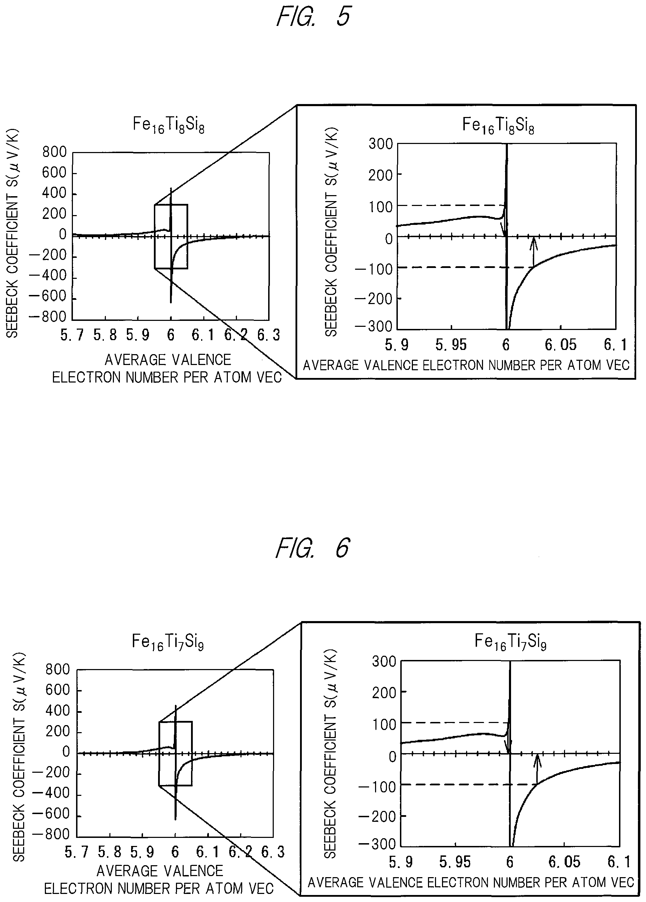

The calculated values of the Seebeck coefficient S expected from the band structure are illustrated in FIGs. 5 to 11. FIGs. 5 to 11 are graphs illustrating a relation between the calculated Seebeck coefficient S and the average valence electron number per atom. In a quadrangle frame of each figure on the right, a part of a range of the average valence electron number per atom in each graph is displayed in an enlarged manner.

Among FIGs. 5 to 11, FIG 5 shows results obtained by calculating the Seebeck coefficient S of the $Fe_2TiA$-based (Fe-Ti-Si-based) full-Heusler alloy having stoichiometric composition among the $Fe_2TiA$-based (Fe-Ti-Si-based) full-Heusler alloys (i.e., the full-Heusler alloy represented by the composition formula $Fe_2TiSi$) by use of the first-principles calculation. In other words, FIG 5 shows the Seebeck coefficient S calculated from the band structure illustrated in FIG 4.

The calculation results illustrated in FIG 5 show that the full-Heusler alloy represented by the composition formula $Fe_2TiSi$ is converted to the p-type or the n-type full-Heusler alloy by adjusting the value of the average valence electron number per atom VEC, and the absolute value of the Seebeck coefficient S becomes maximum in each range of the average valence electron number per atom VEC when converted to each conductivity type. Note that, although not illustrated, as for these tendencies, the same holds for the full-Heusler alloy represented by the composition formula $Fe_2TiSn$.

In the calculation results illustrated in FIG 5, the value of the calculated Seebeck coefficient S becomes +400 $\mu V/K$ in the case of the p-type (the maximum value of the Seebeck coefficient S on the left in FIG 5) and becomes -600 $\mu V/K$ in the case of the n-type (the minimum value of the Seebeck coefficient S on the left in FIG. 5). The value increases up to three times or more, compared to, for example, the $Fe_2VAl$-based full-Heusler alloy having an absolute value of the Seebeck coefficient S of substantially 150 $\mu V/K$. An increase of the Seebeck coefficient S by three times corresponds to an increase of the figure of merit ZT by nine times.

In order to increase the figure of merit ZT to a practical level, it is necessary that an absolute value $|S|$ of the Seebeck coefficient S is 100 $\mu V/K$ or more. Then, it has been found that a range of the VEC satisfying a condition in which the absolute value $|S|$ of the Seebeck coefficient S is 100 $\mu V/K$ or more is a range in which the $\Delta VEC$ which is a difference relative to 6 (i.e., a value of the average valence electron number per atom VEC when the Seebeck coefficient S is 0) is in a range from -0.01 to 0.025.

The thermoelectric conversion material made of $Fe_2TiA$-based Full Heusler alloy may be a thermoelectric conversion material made of $Fe_2TiA$-based Full Heusler alloy having typical stoichiometric composition (Fe: Ti : A = 2 : 1 : 1). It is acceptable to use a thermoelectric conversion material made of $Fe_2TiA$-based Full Heusler alloy having the composition which is shifted from the stoichiometric composition in a predetermined range. Hereinafter, an acceptable predetermined range of the composition will be described.

Among FIGs. 5 to 11, FIGs. 6 to 11 show the results obtained by calculating the Seebeck coefficient S of the $Fe_2TiA$-based (Fe-Ti-Si-based) full-Heusler alloy having the non-stoichiometric composition in which a composition ratio of Fe, Ti, and Si is shifted from the stoichiometric composition, among the $Fe_2TiA$-based (Fe-Ti-Si-based) full-Heusler alloys, by use of the first-principles calculation.

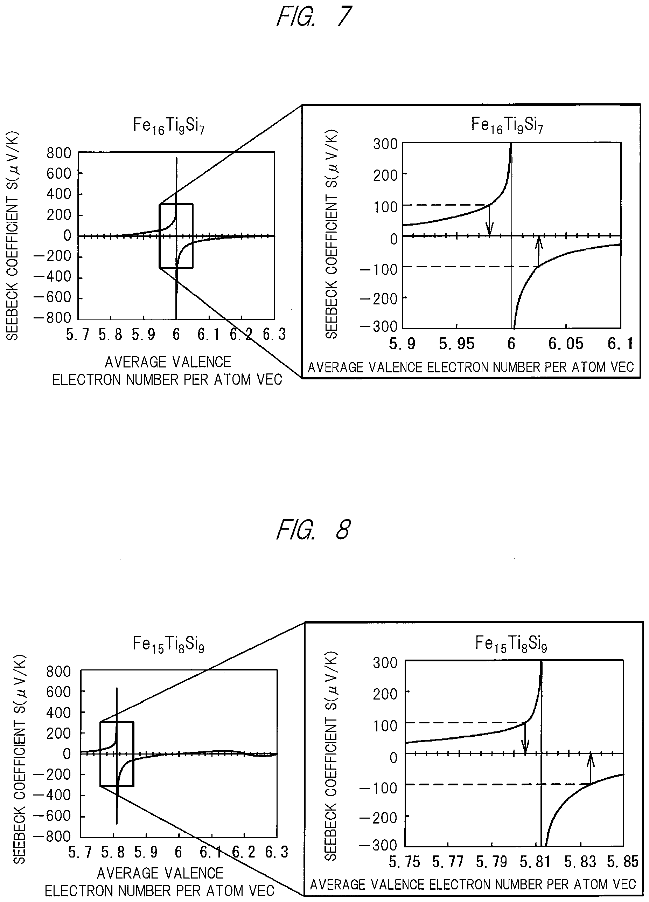

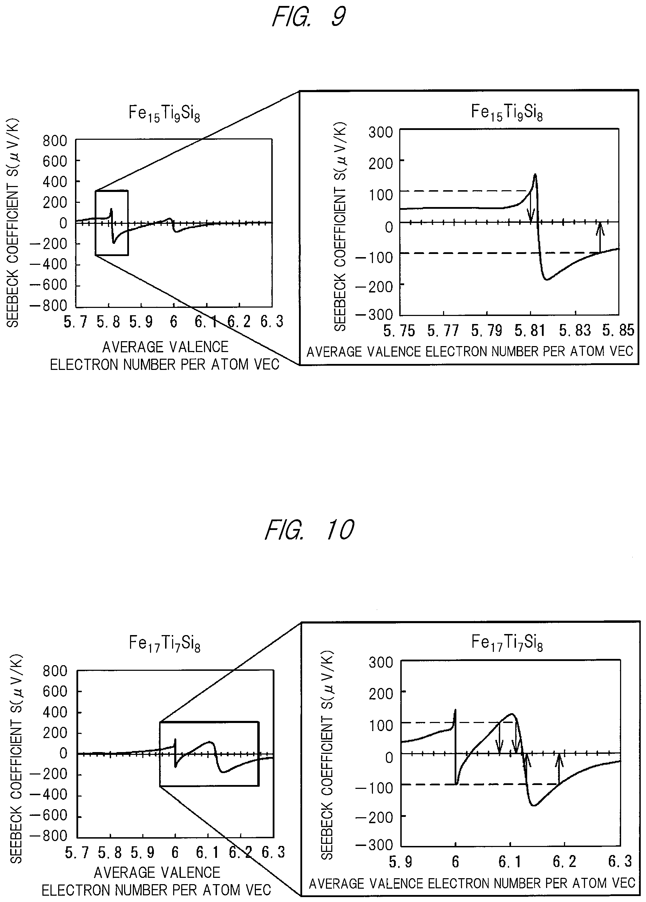

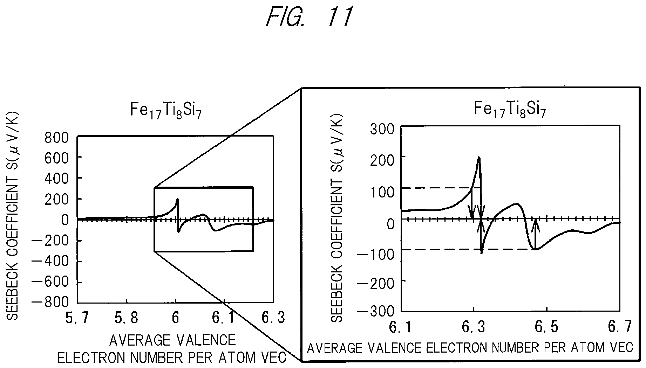

Specifically, assuming a crystal lattice made of 32 atoms (i.e., a 32-atom system), first-principles calculation is performed on the composition in which an atom is substituted one by one from the stoichiometric composition $Fe_{16}Ti_8Si_8$. The composition of $Fe_{16}Ti_7Si_9$ is calculated in FIG 6, the composition of $Fe_{16}Ti_9Si_7$ is calculated in FIG 7, and the composition of $Fe_{15}Ti_8Si_9$ is calculated in FIG 8. Further, the composition of $Fe_{15}Ti_9Si_8$ is calculated in FIG. 9, the composition of $Fe_{17}Ti_7Si_8$ is calculated in FIG 10, and the composition of $Fe_{17}Ti_8Si_7$ is calculated in FIG 11.

As illustrated in FIGs. 10 and 11, it is found that, when the composition ratio of Fe is significantly increased, the electronic state is broken, thereby lowering the performance. Meanwhile, in other composition, even when the non-stoichiometric composition is used, as illustrated in FIGs. 6 to 9, the absolute value of the Seebeck coefficient S is large and is up to substantially 2.5 to 3 times larger than, for example, the $Fe_2VAl$-based full-Heusler alloy having an absolute value of the Seebeck coefficient S of substantially 150 $\mu V/K$. Therefore, it has been found that, even when the composition is modulated from the stoichiometric composition to the extent of a modulated amount of the non-stoichiometric composition, adjusting the composition to an appropriate composition ratio does not result in a decrease in absolute value of the Seebeck coefficient S.

Note that, although not illustrated, almost the same result is obtained also when Sn is used in place of Si. Similarly, although not illustrated, almost the same result is obtained also when a part of Si is substituted by Sn.

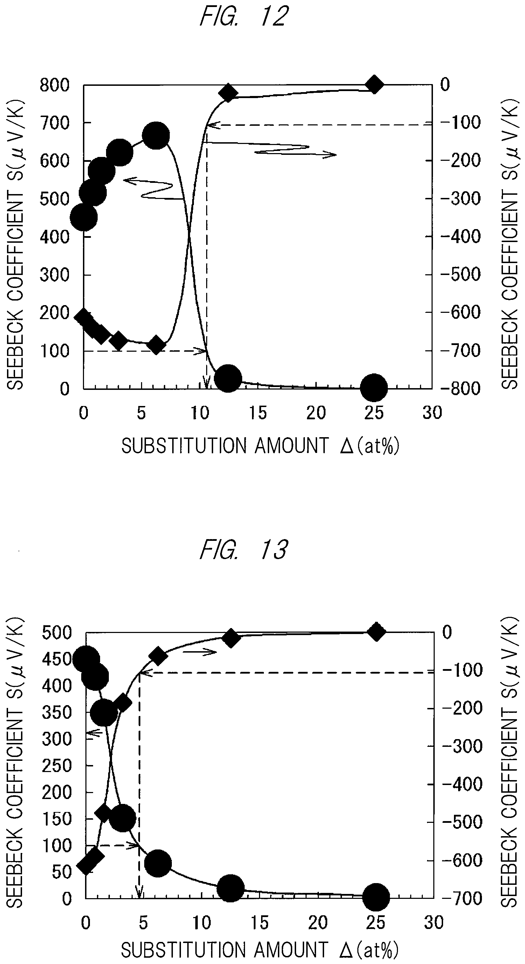

FIGs. 12 to 17 show the modulated amount from the stoichiometric composition to the non-stoichiometric composition, i.e., a relation between the substitution amount $\Delta$ and the Seebeck coefficient S in the $Fe_2TiA$-based (Fe-Ti-Si-based) Heusler alloy. FIGs. 12 to 17 are graphs each illustrating a relation between the calculated Seebeck coefficient S and the substitution amount. Note that, in FIGs. 12 to 17, a vertical axis on the left represents the Seebeck coefficient S in the case of the p-type and a vertical axis on the right represents the Seebeck coefficient S in the case of the n-type.

FIG 12 shows the results of first-principles calculation when the composition ratio of Ti is made equal to the composition ratio of Ti in the stoichiometric composition, the composition ratio of Si is increased compared to the composition ratio of Si in the stoichiometric composition, and the composition ratio of Fe is decreased compared to the composition ratio of Fe in the stoichiometric composition. In other words, FIG 12 shows the results of first-principles calculation when a part of E1-site Fe is substituted by Si in the $Fe_2TiA$-based (Fe-Ti-Si-based) full-Heusler alloy with $L2_1$-type crystal structure represented by $E1_2E2E3$.

FIG 13 shows the results of first-principles calculation when the composition ratio of Si is made equal to the composition ratio of Si in the stoichiometric composition, the composition ratio of Ti is increased compared to the composition ratio of Ti in the stoichiometric composition, and the composition ratio of Fe is decreased compared to the composition ratio of Fe in the stoichiometric composition (i.e., a part of E1-site Fe is substituted by Ti).

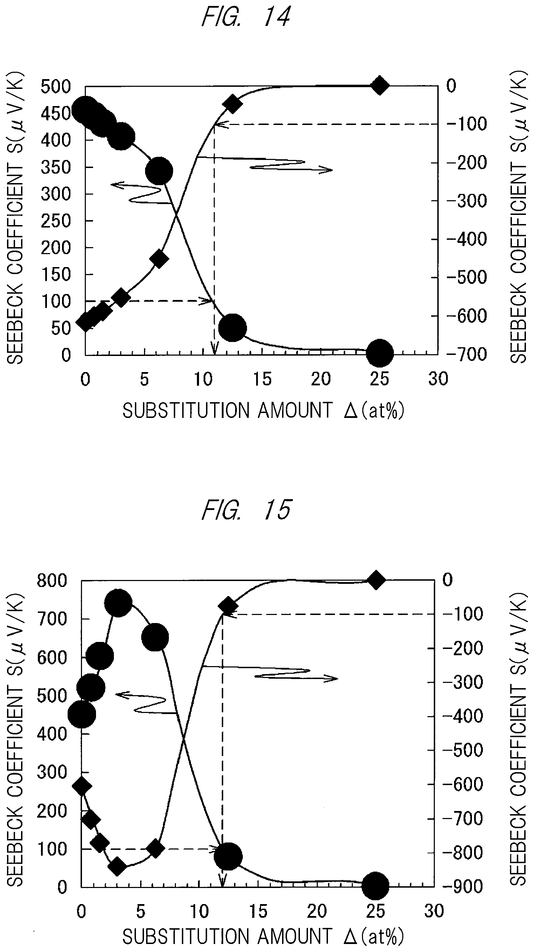

FIG 14 shows the results of first-principles calculation when the composition ratio of Fe is made equal to the composition ratio of Fe in the stoichiometric composition, the composition ratio of Si is increased compared to the composition ratio of Si in the stoichiometric composition, and the composition ratio of Ti is decreased compared to the composition ratio of Ti in the stoichiometric composition (i.e., a part of E2-site Ti is substituted by Si).

FIG. 15 shows the results of first-principles calculation when the composition ratio of Fe is made equal to the composition ratio of Fe in the stoichiometric composition, the composition ratio of Ti is increased compared to the composition ratio of Ti in the stoichiometric composition, and the composition ratio of Si is decreased compared to the composition ratio of Si in the stoichiometric composition (i.e., a part of E3-site Si is substituted by Ti).

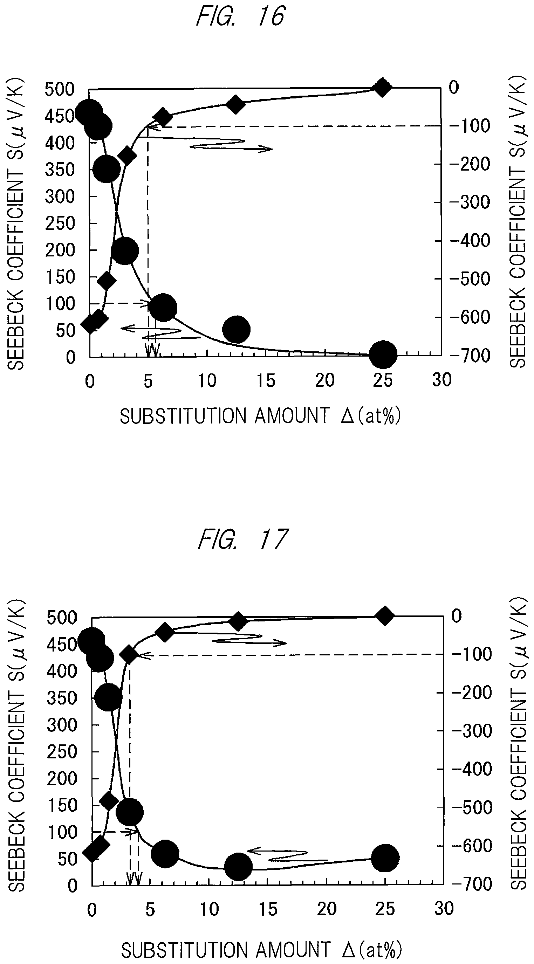

FIG 16 shows the results of first-principles calculation when the composition ratio of Ti is made equal to the composition ratio of Ti in the stoichiometric composition, the composition ratio of Fe is increased compared to the composition ratio of Fe in the stoichiometric composition, and the composition ratio of Si is decreased compared to the composition ratio of Si in the stoichiometric composition (i.e., a part of E3-site Si is substituted by Fe).

FIG 17 shows the results of first-principles calculation when the composition ratio of Si is made equal to the composition ratio of Si in the stoichiometric composition, the composition ratio of Fe is increased compared to the composition ratio of Fe in the stoichiometric composition, and the composition ratio of Ti is decreased compared to the composition ratio of Ti in the stoichiometric composition (i.e., a part of E2-site Ti is substituted by Fe).

Similarly to the calculation results of the 32-atom system which has been described with reference to FIGs. 6 to 11 as mentioned above, the calculation results shown in FIGs. 12 to 17 are obtained by performing first-principles calculation on each of 4-atom, 8-atom, 16-atom, 64-atom, and 128-atom systems in which the element corresponding to an atom is substituted in order to calculate the Seebeck coefficient S. at% of an atom varies depending on the total atomic number in each of the atom systems so that the substitution amount can be represented by at%.

In the case of the 4-atom system and the 8-atom system, the element corresponding to an atom is substituted, whereby the symmetry of the crystal structure significantly changes. For example, in the case of the 4-atom system, substitution between Fe and Ti in $Fe_2TiSi$ results in conversion to $Fe_3Si$ or $FeTi_2Si$, whereby the atom system has another crystal structure. This means that the atom system is largely deviated from the electronic state illustrated in FIG 4. Thus, the absolute value of the Seebeck coefficient S significantly decreases. Similarly, a significant change in the symmetry of the crystal structure causes the 8-atom system to have an atomic arrangement in which a metallic electronic state is easily formed in a unit cell, and the absolute value of the Seebeck coefficient S decreases.

When the composition ratio of Ti is equal, the composition ratio of Si is increased, and the composition ratio of Fe is decreased compared to the stoichiometric composition, the absolute value $|S|$ of the Seebeck coefficient S becomes 100 $\mu$V/K or more. As illustrated by a vertical line of FIG. 12, an acceptable substitution amount for increasing the figure of merit ZT to a practical level is 10.8 at% or less in the case of both the p- and the n-types.

When the composition ratio of Si is equal, the composition ratio of Ti is increased, and the composition ratio of Fe is decreased compared to the stoichiometric composition, the absolute value $|S|$ of the Seebeck coefficient S becomes 100 $\mu$V/K or more. As illustrated by a vertical line of FIG. 13, an acceptable substitution amount for increasing the figure of merit ZT to a practical level is 4.9 at% or less in the case of both the p- and the n-types.

When the composition ratio of Fe is equal, the composition ratio of Si is increased, and the composition ratio of Ti is decreased compared to the stoichiometric composition, the absolute value $|S|$ of the Seebeck coefficient S becomes 100 $\mu$V/K or more. As illustrated by a vertical line of FIG 14, an acceptable substitution amount for increasing the figure of merit ZT to a practical level is 11 at% or less in the case of both the p- and the n-types.

When the composition ratio of Fe is equal, the composition ratio of Ti is increased, and the composition ratio of Si is decreased compared to the stoichiometric composition, the absolute value $|S|$ of the Seebeck coefficient S becomes 100 $\mu$V/K or more. As illustrated by a vertical line of FIG 15, an acceptable substitution amount for increasing the figure of merit ZT to a practical level is 12.0 at% or less in the case of both the p- and the n-types.

When the composition ratio of Ti is equal, the composition ratio of Fe is increased, and the composition ratio of Si is decreased compared to the stoichiometric composition, the absolute value $|S|$ of the Seebeck coefficient S becomes 100 $\mu$V/K or more. As illustrated by a vertical line of FIG 16, an acceptable substitution amount for increasing the figure of merit ZT to a practical level is 5.9 at% or less in the case of the p-type, and an acceptable substitution amount for increasing the figure of merit ZT to a practical level is 5.0 at% or less in the case of the n-type.

When the composition ratio of Si is equal, the composition ratio of Fe is increased, and the composition ratio of Ti is decreased compared to the stoichiometric composition, the absolute value |S| of the Seebeck coefficient S becomes 100 $\mu$V/K or more. As illustrated by a vertical line of FIG 17, an acceptable substitution amount for increasing the figure of merit ZT to a practical level is 4.0 at% or less in the case of the p-type, and an acceptable substitution amount for increasing the figure of merit ZT to a practical level is 3.2 at% or less in the case of the n-type.

FIG 18 shows the results in which a preferable range of the composition determined from these acceptable substitution amounts is illustrated in a ternary phase diagram. FIG. 18 is a ternary phase diagram of Fe-Ti-Si.

When the composition ratio of Fe is equal, the composition ratio of Ti is increased, and the composition ratio of Si is decreased compared to the stoichiometric composition, the maximum acceptable substitution amount is 12.0 at% as illustrated in FIG 15. At this time, the composition, when represented by at% in the ternary phase diagram illustrated in FIG 18, is as follows: (Fe, Ti, Si) = (50,37, 13).

When the composition ratio of Fe is equal, the composition ratio of Si is increased, and the composition ratio of Ti is decreased compared to the stoichiometric composition, the maximum acceptable substitution amount is 11 at% as illustrated in FIG 14. At this time, the composition, when represented by at% in the ternary phase diagram illustrated in FIG 18, is as follows: (Fe, Ti, Si) = (50, 14, 36).

When the composition ratio of Si is equal, the composition ratio of Ti is increased, and the composition ratio of Fe is decreased compared to the stoichiometric composition, the maximum acceptable substitution amount is 4.9 at% as illustrated in FIG 13. At this time, the composition, when represented by at% in the ternary phase diagram illustrated in FIG. 18, is as follows: (Fe, Ti, Si) = (45, 30, 25).

When the composition ratio of Ti is equal, the composition ratio of Si is increased, and the composition ratio of Fe is decreased compared to the stoichiometric composition, the maximum acceptable substitution amount is 10.8 at% as illustrated in FIG 12. At this time, the composition, when represented by at% in the ternary phase diagram illustrated in FIG 18, is as follows: (Fe, Ti, Si) = (39.5, 25, 35.5).

When the composition ratio of Si is equal, the composition ratio of Fe is increased, and the composition ratio of Ti is decreased compared to the stoichiometric composition, the maximum acceptable substitution amount is 4.0 at% as illustrated in FIG. 17. At this time, the composition, when represented by at% in the ternary phase diagram illustrated in FIG 18, is as follows: (Fe, Ti, Si) = (54, 21, 25).

When the composition ratio of Ti is equal, the composition ratio of Fe is increased, and the composition ratio of Si is decreased compared to the stoichiometric composition, the maximum acceptable substitution amount is 5.9 at% as illustrated in FIG 16. At this time, the composition, when represented by at% in the ternary phase diagram illustrated in FIG 18, is as follows: (Fe, Ti, Si) = (55.5, 25, 19.5).

In the ternary phase diagram, the region RG1 surrounded by the six points (50, 37, 13), (45, 30, 25), (39.5, 25, 35.5), (50, 14, 36), (54, 21, 25), and (55.5, 25, 19.5) is a preferable range of the composition.

Here, the p-type or the n-type full-Heusler alloy represented by the composition formula (Chemical Formula 1) when x, y, and z satisfy the relations x = 0, y = 0, and z = 0, respectively, will be discussed. As shown in the mathematical formulas (Mathematical Formula 6) to (Mathematical Formula 8) as described above, $\sigma$ = (u - 50)/25, $\varphi$ = (v - 25)/25, and $\omega$ = (w - 25)/25. In the ternary phase diagram of Fe-Ti-A, a point where Fe is u at%, Ti is v at%, and A is w at% is (u, v, w).

At this time, the point (u, v, w) is located in the region (the region surrounded by the hexagon) RG1 inside the hexagon having the points (50,37,13), (45,30,25), (39.5,25,35.5), (50,14,36), and (54,21,25), and (55.5,25,19.5) as the apexes. In other words, the point (u, v, w) is located in the region RG1 surrounded by the six lines connecting the points (50,37, 13), (45,30,25), (39.5, 25, 35.5), (50, 14,36), (54,21,25), and (55.5, 25, 19.5) in this order.

Consequently, the absolute value |S| of the Seebeck coefficient S becomes 100 $\mu$V/K or more, and thus, it is possible to increase the figure of merit ZT to a practical level.

Note that the description "located in the region inside the hexagon" includes a case of being located on each of the six sides of the hexagon. Further, the description "located in the region surrounded by six lines" includes a case of being located on each of the six lines.

Further, in the ternary phase diagram, a region RG2 surrounded by six points (Fe, Ti, A) = (50, 35,15), (47.5, 27.5,25), (40, 25, 35), (50, 17, 33), (52.2, 22.8, 25), and (52.8, 25, 22.2) is a more preferable range of the composition.

In other words, the point (u, v, w) is located in the region (the region surrounded by the hexagon) RG2 inside the hexagon having the points (50, 35,15), (47.5, 27.5, 25), (40, 25, 35), (50, 17, 33), (52.2, 22.8, 25), and (52.8, 25, 22.2) as the apexes in the ternary phase diagram. In other words, the point (u, v, w) is located in the region RG2 surrounded by six lines connecting the points (50, 35, 15), (47.5, 27.5, 25), (40, 25, 35), (50, 17, 33), (52.2, 22.8, 25), and (52.8, 25, 22.2) in this order.

Consequently, it is possible to further increase the absolute value |S| of the Seebeck coefficient S and further increase the figure of merit ZT.

Further, in the ternary phase diagram, a region RG3 surrounded by six points (Fe, Ti, A) = (50, 32.6, 17.4), (49.2,25.8,25), (43.9, 25, 31.1), (50, 23, 27), (51, 24, 25), and (51, 25, 24) is a more preferable range of the composition.

In other words, the point (u, v, w) is located in the region (the region surrounded by the hexagon) RG3 inside a hexagon having the points (50, 32.6, 17.4), (49.2, 25.8, 25), (43.9, 25, 31.1), (50, 23, 27), (51, 24, 25), and (51, 25, 24) as the apexes in the ternary phase diagram. In other words, the point (u, v, w) is located in the region RG3 surrounded by six lines connecting the points (50, 32.6, 17.4), (49.2, 25.8, 25), (43.9, 25, 31.1), (50, 23, 27), (51, 24, 25), and (51, 25, 24) in this order.

As illustrated in FIG 12, knowledge that the Seebeck coefficient S is further increased compared to the stoichiometric composition when the composition ratio of Si is increased and the composition ratio of Fe is decreased is obtained, and such knowledge has not been known in the past. Specifically, it has been found that, in the case of having the composition in which the composition ratio of Si is increased by 1 to 9 at% and the composition ratio of Fe is decreased by 1 to 9 at% compared to the stoichiometric composition, the Seebeck coefficient S is further increased. In other words, it has been found that, in a case in which $\sigma$ satisfies the relation $-0.36 \leq \sigma \leq -0.04$ when converted to the composition formula $Fe_{2+\sigma}Ti_{1+\varphi}Si_{1+\omega}$, the Seebeck coefficient S is further increased compared to the stoichiometric composition ($\sigma = \varphi = \omega = 0$).

Further, it has been found that, in the case of having the composition in which the composition ratio of Si is increased by 2 to 8 at% and the composition ratio of Fe is decreased by 2 to 8 at% compared to the stoichiometric composition, the Seebeck coefficient S is further increased. In other words, it has been found that, in a case in which $\sigma$ satisfies the relation $-0.32 \leq \sigma \leq -0.08$ when converted to the composition formula $Fe_{2+\sigma}Ti_{1+\varphi}Si_{1+\omega}$, the Seebeck coefficient S is further increased compared to the stoichiometric composition ($\sigma = \varphi = \omega = 0$).

Similarly, as illustrated in FIG. 15, knowledge that the Seebeck coefficient S is further increased compared to the stoichiometric composition when the composition ratio of Ti is increased and the composition ratio of Si is decreased is obtained, and such knowledge has not been known in the past. Specifically, it has been found that, in the case of having the composition in which the composition ratio of Ti is increased by 1 to 8 at% and the composition ratio of Si is decreased by 1 to 8 at% compared to the stoichiometric composition, the Seebeck coefficient S is further increased. In other words, it has been found that, in a case in which $\varphi$ satisfies the relation $0.04 \leq \varphi \leq 0.32$ when converted to the composition formula $Fe_{2+\sigma}Ti_{1+\varphi}Si_{1+\omega}$, the Seebeck coefficient S is increased compared to the stoichiometric composition ($\sigma = \varphi = \omega = 0$).

Further, it has been found that, in the case of having the composition in which the composition ratio of Ti is increased by 2 to 7 at% and the composition ratio of Si is decreased by 2 to 7 at% compared to the stoichiometric composition, the Seebeck coefficient S is further increased. In other words, it has been found that, in a case in which $\varphi$ satisfies the relation $0.08 \leq \varphi \leq 0.28$ when converted to the composition formula $Fe_{2+\sigma}Ti_{1+\varphi}Si_{1+\omega}$, the Seebeck coefficient S is further increased compared to the stoichiometric composition ($\sigma = \varphi = \omega = 0$).

Note that the same results as those described above were obtained also in the case of using Sn in place of Si.

Preferably, an advantageous effect is observed when a part of Ti is substituted by vanadium (V). Hence, M2 is V. At this time, y in the composition formula (Chemical Formula 1) is in a range of y ≤ 0.25. The reason of this will be described in Examples below.

Meanwhile, when M1 is Cu in the composition formula (Chemical Formula 1), the absolute value of the Seebeck coefficient S of the full-Heusler alloy is readily increased.

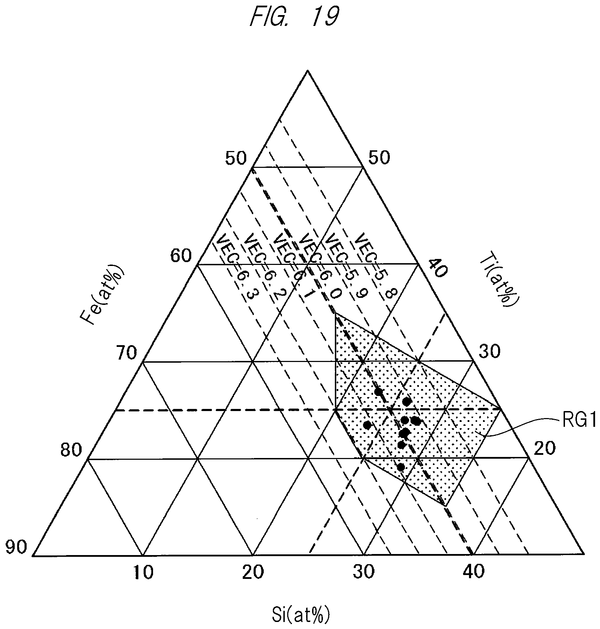

FIG 19 is a ternary phase diagram of Fe-Ti-Si. FIG 19 illustrates the region RG1 which is the same as the region RG1 of FIG 18, and a plurality of points corresponding to the composition ratio of the actually produced sample are plotted in the region RG1. A sample with sufficiently high Seebeck coefficient S is obtained from the samples produced at the composition ratios of the plurality of points.

<Preferable Range of Average Crystal Grain Size of Thermoelectric Conversion Material>

The figure of merit ZT can be increased by not only controlling the VEC of the $Fe_2TiA$-based Full Heusler alloy, but also decreasing the average crystal grain size of the thermoelectric conversion material (hereinafter simply referred to as "crystal grain size"). This will be described hereinafter.

A cause for low figure of merit ZT of the metal-based thermoelectric conversion material is mainly that the thermal conductivity $\kappa$ thereof is high. A cause for the high thermal conductivity $\kappa$ of the metal-based thermoelectric conversion material is that, since a mean free path of phonon is long, heat conduction through lattice vibration is promoted.

As means reducing thermal conductivity $\kappa$ derived from lattice vibration, there is means controlling an organization structure of the themioelectric conversion material. Specifically, it is to decrease the average crystal grain size of the metal-based thermoelectric conversion material.

As mentioned above, in order to increase the figure of merit ZT, it is desirable to reduce the thermal conductivity $\kappa$ from the mathematical formula (Mathematical Formula 5). Further, in order to reduce the thermal conductivity $\kappa$, it is desirable to decrease the crystal grain size as mentioned above.

Hereinafter, a relation between the thermal conductivity $\kappa$ and the crystal grain size will be described.

The thermal conductivity $\kappa$ is represented by a mathematical formula (Mathematical Formula 11) below:
[Mathematical Formula 11]

$$\kappa = k_f \times C_p \times \zeta \qquad \text{... (Mathematical Formula 11)}$$

Here, $C_p$ is a specific heat at constant pressure of the thermoelectric conversion material, and $\zeta$ is a density of the thermoelectric conversion material. Further, a constant $k_f$ is represented by a mathematical formula (Mathematical Formula 12) below.
[Mathematical Formula 12]

$$k_f = \frac{d_a}{\pi_f} \qquad \text{... (Mathematical Formula 12)}$$

Here, d is an average crystal grain size of the thermoelectric conversion material, and $\tau_f$ is a period of time when heat is transmitted from a back surface to a front surface of the crystal grain of the thermoelectric conversion material.

As shown in the mathematical formula (Mathematical Formula 11) and the mathematical formula (Mathematical Formula 12), as the average crystal grain size d of the thermoelectric conversion material becomes smaller, the thermal conductivity $\kappa$ of the thermoelectric conversion material becomes smaller. Thus, in the thermoelectric conversion material made of full-Heusler alloy, the figure of merit ZT is further increased by increasing the Seebeck coefficient S while controlling the electronic state of the thermoelectric conversion material and further decreasing the average crystal grain size d, thereby enhancing the thermoelectric conversion characteristics.

However, in order to increase the figure of merit ZT, even in a state where the crystal grain size is decreased and the thermal conductivity $\kappa$ is decreased, it is necessary to further find out some conditions under which a large output factor (= $S^2/\rho$) can be obtained. That is, this is because, when the crystal grain size of the full-Heusler alloy as the usual metal-based thermoelectric conversion material is decreased, the output factor (= $S^2/\rho$) is decreased, so that the figure of merit ZT becomes only the same level or smaller.

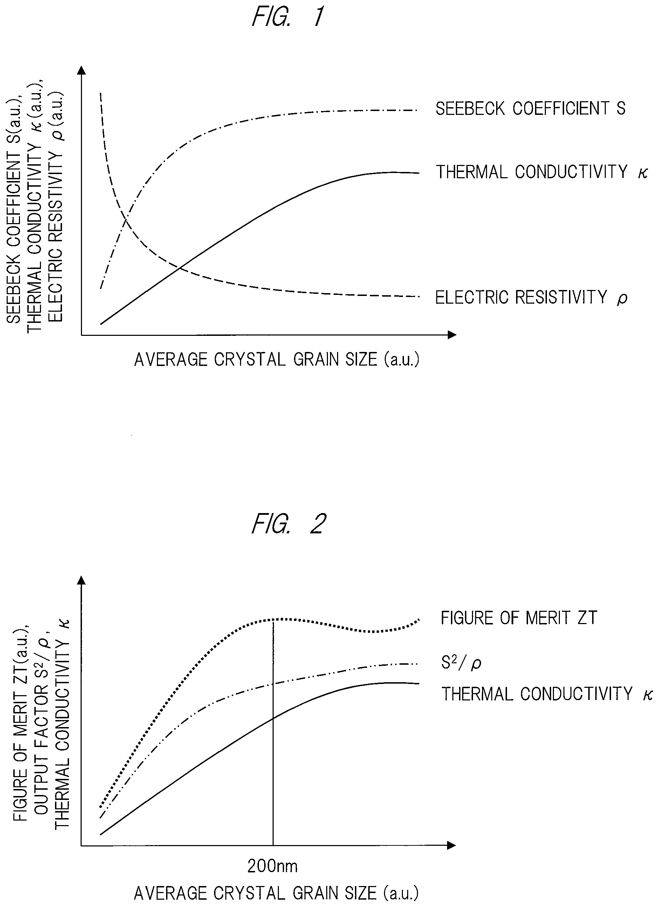

For example, in the case of the $Fe_2VAl$-based thermoelectric conversion material used as the full-Heusler alloy, as illustrated in FIG 1, the average crystal grain size is decreased and the thermal conductivity $\kappa$ is decreased, whereby the electric resistivity $\rho$ is increased. Thus, the output factor $S^2/\rho$ in the figure of merit ZT = {$S^2/(\kappa\rho)$}T represented by the mathematical formula (Mathematical Formula 5) is decreased. Accordingly, in the case of the $Fe_2VAl$-based thermoelectric conversion material, as illustrated in FIG 2, even when the average crystal grain size is decreased, the figure of merit ZT is decreased. For example, even when the grain size is decreased to substantially 200 nm, the figure of merit ZT is not increased to the expected extent.

In the case of the $Fe_2TiA$-based Full Heusler alloy, as different from the case of the $Fe_2VAl$-based full-Heusler alloy, the average crystal grain size is decreased and the thermal conductivity $\kappa$ is decreased, whereby basically the output factor (= $S^2/\rho$) is slightly decreased. On the contrary, as mentioned below, the composition and the grain size are controlled, whereby the output factor is significantly increased, in some cases.

Preferably, the average crystal grain size of the $Fe_2TiA$-based Full Heusler alloy is 30 nm or more and 500 nm or less. Thus, it is possible to increase the figure of merit ZT compared to the case of an average crystal grain size of 1 $\mu$m or more. In order to further increase the figure of merit ZT, the average crystal grain size is more preferably 30 nm or more and 200 nm or less. Also, in order to further increase the figure of merit ZT, the average crystal grain size is still more preferably 30 nm or more and 140 nm or less.

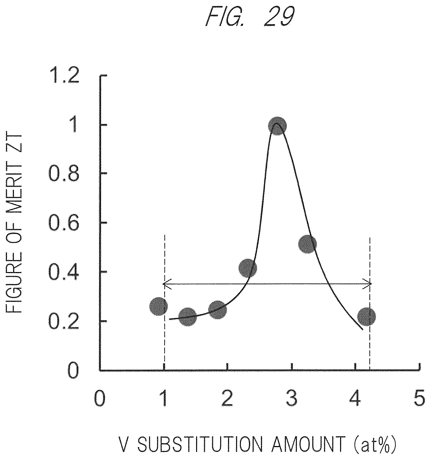

Further, in order to suppress an increase of the electric resistivity $\rho$ while decreasing the crystal grain size and to further increase an effect of suppressing a decrease of the Seebeck coefficient S, the content (addition amount) of Cu is 0.5 at% or more and 1.6 at% ore less. Further, the $Fe_2TiA$-based Full Heusler alloy contains V (vanadium). As described with reference to FIG. 29 below, the content of V is 1.0 at% or more and 4.2 at% or less.

In order to obtain an $Fe_2TiSi$-based Heusler alloy having an average crystal grain size of 3 nm or more and 500 nm or less, for example, an amorphized $Fe_2TiA$-based raw powder is heat-treated, so that a thermoelectric conversion material having an average crystal grain size of less than 1 $\mu$m can be produced. Further, as a method of producing the amorphized $Fe_2TiA$-based raw powder, a method of mechanical alloying or melting the raw material before rapidly quenching it can be used, for example.

In a step of heat-treating the amorphized $Fe_2TiA$-based raw powder, the higher a temperature for heat treatment is, or the longer a time for heat treatment is, the average crystal grain size of the thermoelectric conversion material to be produced is increased. The temperature and the time for heat treatment are appropriately set, so that the average crystal grain size can be controlled. For example, the temperature for heat treatment is preferably from 550 to 700°C, and the time for heat treatment is preferably three minutes or longer and 10 hours or shorter.

Further, in order to achieve a condition in which the average crystal grain size is in a range from 30 to 500 nm, it is desirable to use a method of placing an amorphized $Fe_2TiA$-based raw powder in a die made of carbon or a die made of tungsten carbide, and sintering the powder while applying a pulse current under a pressure of 40 MPa to 5 GPa in an inert gas atmosphere. In the sintering, it is preferable that the temperature is increased to a target temperature in the range of 550 to 700°C and the raw powder is maintained at the target temperature for 3 to 180 minutes and then cooled to room temperature.

As mentioned above, the content (addition amount) of Cu in an $Fe_2TiA$-based raw material is greater than 0 at% and 6 at% or less, whereby the average crystal grain size can be easily decreased.

One portion of Cu forms a solid solution with the crystal of the full-Heusler alloy as a main phase, and another portion of Cu does not form a solid solution with the crystal of the full-Heusler alloy as the main phase. Thus, the amorphized $Fe_2TiA$-based raw powder is heat-treated, whereby one portion thereof is located at each of the E1 site, the E2 site, or the E3 site in the $L2_1$-type crystal structure represented by $E1_2E2E3$, and another portion thereof precipitates separately from the main phase and crystallizes. Further, the full-Heusler alloy contains Cu, whereby a crystal which contains the element as a main component and which is different from the full-Heusler alloy as the main phase prevents growth of the crystal having a main $Fe_2TiA$-based phase. Consequently, it is possible to decrease the crystal grain size. Further, the full-Heusler alloy contains at least one element selected from the group including Cu, whereby the element forms a solid solution with the full-Heusler alloy as the main phase. Consequently, the electronic state of the full-Heusler alloy itself can also be controlled.

Further, when an element such as carbon (C), oxygen (O), or nitrogen (N) forms a solid solution with the full-Heusler alloy as the main phase, an alloy or a compound is formed at a temperature lower than a precipitation temperature of the main phase. Thus, the element such as carbon (C), oxygen (O), or nitrogen (N) forms a solid solution with the full-Heusler alloy as the main phase, whereby the crystal grain size can be decreased in the same manner described above.

Note that, as a method of making the $Fe_2TiA$-based raw material amorphized, a method such as roll rapid quenching or atomizing can be used. When the amorphized $Fe_2TiA$-based raw material is not obtained in a powder state, a method of grinding the raw material in an environment where hydrogen embrittles and oxidation is prevented may be used.

As a method of molding the raw material, various methods such as pressure molding can be used. Also, the raw material is sintered in a magnetic field, thereby obtaining a sintered body with magnetic field orientation. Further, it is possible to use a spark plasma sintering method capable of simultaneously performing pressure molding and sintering.

<Thermoelectric Conversion Module>

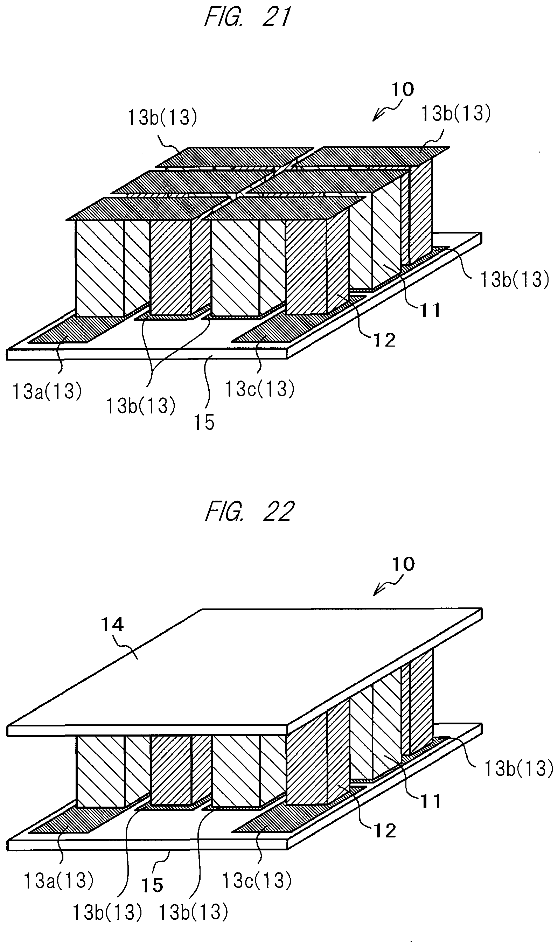

Subsequently, a thermoelectric conversion module obtained by use of the thermoelectric conversion material of the present embodiment will be described. FIG. 21 is a view illustrating a configuration of a thermoelectric conversion module obtained by use of the thermoelectric conversion material of the present embodiment FIG 22 is a view illustrating the configuration of the thermoelectric conversion module obtained by use of the thermoelectric conversion material of the present embodiment. FIG 21 shows a state before attaching an upper substrate, and FIG 22 shows a state after attaching the upper substrate.

The thermoelectric conversion material of the present embodiment can be mounted on, for example, a thermoelectric conversion module 10 illustrated in FIG 21 and FIG 22. The thermoelectric conversion module 10 has a p-type thermoelectric conversion unit 11, an n-type thermoelectric conversion unit 12, a plurality of electrodes 13, an upper substrate 14, and a lower substrate 15. Further, the thermoelectric conversion module 10 has electrodes 13a, 13b, and 13c as the plurality of electrodes 13.

The p-type thermoelectric conversion unit 11 and the n-type thermoelectric conversion unit 12 are alternately arranged between the electrode 13a and the electrode 13c serving as a voltage extraction unit via the electrode 13b and electrically connected in series. For example, they can be arranged as shown in FIG 21. Further, the p-type thermoelectric conversion unit 11, the n-type thermoelectric conversion unit 12, the electrodes 13a, 13b, and 13c, the upper substrate 14, and the lower substrate 15 are connected so as to be thermally in contact with one another. At this time, for example, the upper substrate 14 is heated or allowed to be in contact with a high temperature portion, so that a temperature gradient can be generated between the p-type and the n-type thermoelectric conversion units 11 and 12 in the same direction. Thus, according to the principle of the Seebeck effect, a thermoelectromotive force is generated in the p-type and the n-type thermoelectric conversion units 11 and 12. At this time, in the p-type and the n-type thermoelectric conversion units 11 and 12, the thermoelectromotive force is generated in the opposite direction to the temperature gradient, whereby the thermoelectromotive force is not canceled, but added. Accordingly, it is possible to generate a large thermoelectromotive force form the thermoelectric conversion module 10. In addition to a method of establishing a temperature gradient as described above, the lower substrate 15 may be cooled or allowed to be in contact with a low temperature portion. Further, the upper substrate 14 is heated or allowed to be in contact with the high temperature portion, and the lower substrate 15 may be cooled or allowed to be in contact with the low temperature portion.

Each of the p-type and the n-type thermoelectric conversion units 11 and 12 includes the thermoelectric conversion material. As the thermoelectric conversion material included in each of the p-type and the n-type thermoelectric conversion units 11 and 12, the thermoelectric conversion material of the present embodiment can be used. In this regard, as the p-type thermoelectric conversion unit 11, the thermoelectric conversion material made of full-Heusler alloy having the composition different from that of the $Fe_2TiA$-based Full Heusler alloy such as $Fe_2NbAl$ or $FeS_2$ can be used.

Meanwhile, as the material of each of the upper substrate 14 and the lower substrate 15, gallium nitride (GaN), silicon nitride (SiN), or the like can be used. Further, as the material of each of the electrodes 13, copper (Cu) or gold (Au) can be used, for example.

Examples

Hereinafter, the present embodiment will be described in more detail with reference to Examples. Note that the present invention is not limited to the following Examples.

Each thermoelectric conversion material of the present invention was produced by the following method.

In the thermoelectric conversion material made of full-Heusler alloy with $L2_1$-type crystal structure represented by $E1_2E2E3$, iron (Fe), titanium (Ti), and silicon (Si) were used as raw materials as main components of each of the E1 site, the E2 site, and the E3 site. Further, as raw materials for substituting the main components at each of the E1 site, the E2 site, or the E3 site, copper (Cu), vanadium (V), and tin (Sn) were used. Then, each of the raw materials was weighed so as to allow the thermoelectric conversion material to be produced to have a desired composition.

Thereafter, the raw materials were placed in a stainless steel container in an inert gas atmosphere and mixed with stainless steel balls having a diameter of 10 mm. After that, mechanical alloying was performed using a planetary ball milling apparatus at an orbital rotation speed of 200 to 500 rpm for 20 hours or more, and an amorphized alloy powder was obtained. The amorphized alloy powder was placed in a die made of carbon or a die made of tungsten carbide and sintered while applying a pulse current under a pressure of 40 MPa to 5 GPa in an inert gas atmosphere. During the sintering, the temperature was increased to a target temperature in the range of 550 to 700°C, and the die was maintained at the target temperature for 3 to 180 minutes and cooled to room temperature, thereby obtaining a thermoelectric conversion material.

The average crystal grain size of the obtained thermoelectric conversion material was evaluated through a transmission electron microscope (TEM) and an X-ray diffraction (XRD) method. Further, a thermal diffusivity of the obtained thermoelectric conversion material was measured by a laser flash method, the specific heat of the obtained thermoelectric conversion material was measured by differential scanning calorimetry (DSC), and the thermal conductivity $\kappa$ was calculated from the measured thermal diffusivity and specific heat. Further, the electric resistivity $\rho$ and the Seebeck coefficient S were measured by use of a thermoelectric characteristics evaluation device ZEM (manufactured by ULVAC-RIKO, Inc.).

The obtained measurement results are indicated in Tables 1 and 2. Table 1 indicates the measurement results of Comparative Examples 1 "-6", and Table 2 indicates the measurement of Comparative Example 7". Further, for comparison, Table 3 indicates the results in which the crystal grain size of the thermoelectric conversion material made of $Fe_2VAl$-based full-Heusler alloy was decreased from substantially 1000 nm to 200 nm. Table 3 indicates the results of Comparative Examples 1 to 4. Further, Tables 4 and 5 indicate the measurement results when Cu was added. Table 4 indicates the measurement results of Comparative Examples 8, 9 and Examples 10 to 18, and Table 5 indicates the measurement results ofExamples 19 to 29.

[Table 1]

| | Fe (at%) | Cu (at%) | Ti (at%) | V (at%) | Si (at%) | Δ VEC | AVERAGE CRYSTAL GRAIN SIZE (nm) | SEEBECK COEFFICIENT S($\mu$V/K) | ELECTRIC RESISTIVITY $\rho(\mu\Omega$m) | THERMAL CONDUCTIVITY $\kappa$(W/Km) | OUTPUT FACTOR (mW/K$^2$m) | FIGURE OF MERIT ZT |
|---|---|---|---|---|---|---|---|---|---|---|---|---|
| Comparative | 49.5 | 0 | 21.4 | 2.4 | 26.7 | 0.12 | 39.3 | -87.6 | 12.2 | 1.71 | 0.63 | 0.12 |
| | 49.5 | 0 | 21.4 | 2.4 | 26.7 | 0.12 | 64.3 | -113.8 | 10.8 | 0.94 | 1.2 | 0.41 |
| | 49.5 | 0 | 21.4 | 2.4 | 26.7 | 0.12 | 94.1 | -119.3 | 11.2 | 1.13 | 1.27 | 0.36 |
| | 49.5 | 0 | 21.4 | 2.4 | 26.7 | 0.12 | 109.4 | -120.6 | 11.6 | 1.23 | 1.25 | 0.32 |
| | 49.5 | 0 | 21.4 | 2.4 | 26.7 | 0.12 | 115.7 | -122 | 10.8 | 1.2 | 1.38 | 0.37 |
| | 49.5 | 0 | 21.4 | 2.4 | 26.7 | 0.12 | 130.6 | -120.3 | 10.2 | 1.55 | 1.42 | 0.3 |

[Table 2]

| | Fe (at%) | Ti (at%) | V (at%) | Si (at%) | Sn (at%) | Δ VEC | AVERAGE CRYSTAL GRAIN SIZE (nm) | SEEBECK COEFFICIENT $S(\mu V/K)$ | ELECTRIC RESISTIVITY $\rho(\mu \Omega m)$ | THERMAL CONDUCTIVITY $\kappa(W/Km)$ | OUTPUT FACTOR (mW/K$^2$m) | FIGURE OF MERIT ZT |
|---|---|---|---|---|---|---|---|---|---|---|---|---|
| Comparative Example 7 | 49.5 | 21.4 | 2.4 | 25.3 | 1.4 | 0.12 | 51.8 | -152.9 | 16.9 | 1.9 | 1.38 | 0.25 |

[Table 3]

| | Fe (at%) | V (at%) | Al (at%) | Si (at%) | Bi (at%) | Δ VEC | AVERAGE CRYSTAL GRAIN SIZE (nm) | SEEBECK CO-EFFICENT S ($\mu$V/K) | ELECTRIC RE-SISTIVITY $\rho$($\mu$ $\Omega$m) | THERMAL CON-DUCTIVITY $\kappa$ (W/Km) | OUTPUT FACTOR (mW/K$^2$m) | FIGURE OF MERIT ZT |
|---|---|---|---|---|---|---|---|---|---|---|---|---|
| COMPARATIVE EXAMPLE 1 | 49.4 | 24.7 | 22.2 | 2.5 | 1.2 | 0.10 | 1000 | -118 | 2.94 | 13.5 | 4.73 | 0.1 |
| COMPARATIVE EXAMPLE 2 | 49.4 | 24.7 | 22.2 | 2.5 | 1.2 | 0.10 | 200-300 | -105 | 4.26 | 7.5 | 2.59 | 0.12 |
| COMPARATIVE EXAMPLE 3 | 50 | 25 | 22.5 | 2.5 | 0 | 0.10 | 200-300 | - | - | 12.0 | 4.2 | 0.1 |
| COMPARATIVE EXAMPLE 4 | 50 | 25 | 22.5 | 2.5 | 0 | 0.10 | 100-200 | - | - | 6.0 | 1.3 | 0.08 |

[Table 4]

| | Fe (at%) | Cu (at%) | Ti (at%) | V (at%) | Si (at%) | Δ VEC | AVERAGE CRYSTAL GRAIN SIZE (nm) | SEEBECK COEFFICIENT S($\mu$V/K) | ELECTRIC RESISTIVITY $\rho$($\mu\Omega$m) | THERMAL CONDUCTIVITY $\kappa$(W/Km) | OUTPUT FACTOR (mW/K²m) | FIGURE OF MERIT ZT |
|---|---|---|---|---|---|---|---|---|---|---|---|---|
| Comparative | 49.52 | 0.00 | 21.43 | 2.38 | 26.67 | 0.12 | 30.90 | -142.2 | 12.9 | 2.25 | 1.57 | 0.24 |
| Comparative Example 9 | 49.40 | 0.25 | 21.38 | 2.38 | 26.59 | 0.15 | 27.54 | -141.8 | 24.3 | 2.23 | 0.83 | 0.13 |
| EXAMPLE 10 | 48.90 | 1.25 | 21.16 | 2.35 | 26.34 | 0.23 | 47.48 | -155.4 | 15.3 | 2.2 | 1.58 | 0.25 |
| EXAMPLE 11 | 48.78 | 1.50 | 21.11 | 2.35 | 26.26 | 0.23 | 48.06 | -172.5 | 20.2 | 2.12 | 1.47 | 0.24 |
| EXAMPLE 12 | 48.66 | 1.75 | 21.05 | 2.34 | 26.20 | 0.20 | 64.22 | -123.7 | 6.88 | 2.3 | 2.22 | 0.34 |
| EXAMPLE 13 | 49.26 | 1.00 | 21.35 | 1.86 | 26.53 | 0.20 | 49.80 | -168.1 | 13.9 | 3.02 | 2.03 | 0.23 |
| EXAMPLE 14 | 49.26 | 1.00 | 20.89 | 2.32 | 26.53 | 0.23 | 48.78 | -157 | 8.78 | 2.64 | 2.81 | 0.37 |
| EXAMPLE 15 | 49.26 | 1.00 | 20.43 | 2.79 | 26.52 | 0.25 | 41.21 | -148 | 4.26 | 1.83 | 5.14 | 0.98 |
| EXAMPLE 16 | 49.26 | 1.00 | 19.96 | 3.25 | 26.53 | 0.27 | 36.67 | -143 | 6.32 | 2.23 | 3.24 | 0.50 |
| EXAMPLE 17 | 49.20 | 1.12 | 22.25 | 0.93 | 26.50 | 0.16 | 51.65 | -138.7 | 8.9 | 2.62 | 2.16 | 0.29 |
| EXAMPLE 18 | 49.20 | 1.12 | 21.79 | 1.39 | 26.50 | 0.18 | 51.43 | -129.7 | 8.04 | 2.99 | 2.09 | 0.24 |

[Table 5]

| | Fe (at%) | Cu (at%) | Ti (at%) | V (at%) | Si (at%) | Sn (at%) | Δ VEC | AVERAGE CRYSTAL GRAIN SIZE (nm) | SEEBECK CO-EFFICENT S ($\mu$V/K) | ELECTRIC RE-SISTIVITY $\rho$($\mu\Omega$m) | THERMAL CON-DUCTIVITY K (W/Km) | OUTPUT FACTOR (mW/K$^2$m) | FIGURE OF MERIT ZT |
|---|---|---|---|---|---|---|---|---|---|---|---|---|---|
| EXAMPLE 19 | 49.45 | 0.75 | 19.54 | 3.72 | 25.88 | 0.66 | 0.27 | 35 | -129.2 | 8.46 | 2.32 | 1.97 | 0.3 |
| EXAMPLE 20 | 49.39 | 0.75 | 19.08 | 4.19 | 24.6 | 1.99 | 0.29 | 22.5 | -80.2 | 6.42 | 1.47 | 1 | 0.24 |
| EXAMPLE 21 | 49.01 | 1.50 | 20.79 | 2.31 | 24.41 | 1.98 | 0.15 | 37 | -138.2 | 9.35 | 2.33 | 2.04 | 0.31 |
| EXAMPLE 22 | 49.26 | 1 | 21.36 | 1.86 | 25.86 | 0.66 | 0.20 | 31.6 | -141.3 | 18 | 2.93 | 1.11 | 0.13 |
| EXAMPLE 23 | 49.26 | 1 | 20.90 | 2.32 | 25.86 | 0.66 | 0.23 | 34.2 | -167.1 | 20.2 | 3.89 | 1.38 | 0.12 |
| EXAMPLE 24 | 49.26 | 1 | 19.97 | 3.25 | 25.86 | 0.66 | 0.27 | 27 | -132.7 | 13.2 | 1.43 | 1.34 | 0.33 |
| EXAMPLE 25 | 49.26 | 1 | 20.89 | 2.32 | 24.54 | 1.99 | 0.23 | 39.3 | -136.3 | 10.1 | 3.01 | 1.83 | 0.21 |
| EXAMPLE 26 | 49.26 | 1 | 20.42 | 2.79 | 24.54 | 1.99 | 0.25 | 49.2 | -141.9 | 4.8 | 2.66 | 4.19 | 0.55 |
| EXAMPLE 27 | 49.26 | 1 | 19.96 | 3.25 | 24.54 | 1.99 | 0.27 | 42.7 | -131.5 | 8.24 | 1.38 | 2.1 | 0.53 |
| EXAMPLE 28 | 49.26 | 1 | 20.43 | 2.79 | 25.86 | 0.66 | 0.25 | - | -135.2 | 8.52 | 3.04 | 2.14 | 0.25 |
| EXAMPLE 29 | 49.26 | 1 | 21.35 | 1.86 | 24.54 | 1.99 | 0.20 | - | -134.7 | 10.8 | 3.89 | 1.68 | 0.15 |

As indicated in Tables 1, 2, 4, and 5, when the full-Heusler alloy containing Fe, Ti, and A as the main components is one in which the amount of change $\Delta$VEC of the average valence electron number per atom VEC satisfies the relation $0 < |\Delta VEC| \leq 0.2$ or $0.2 < |\Delta VEC| \leq 0.3$, the figure of merit ZT is greater than 0.1.

Subsequently, a relation between the average crystal grain size and the characteristics was studied.

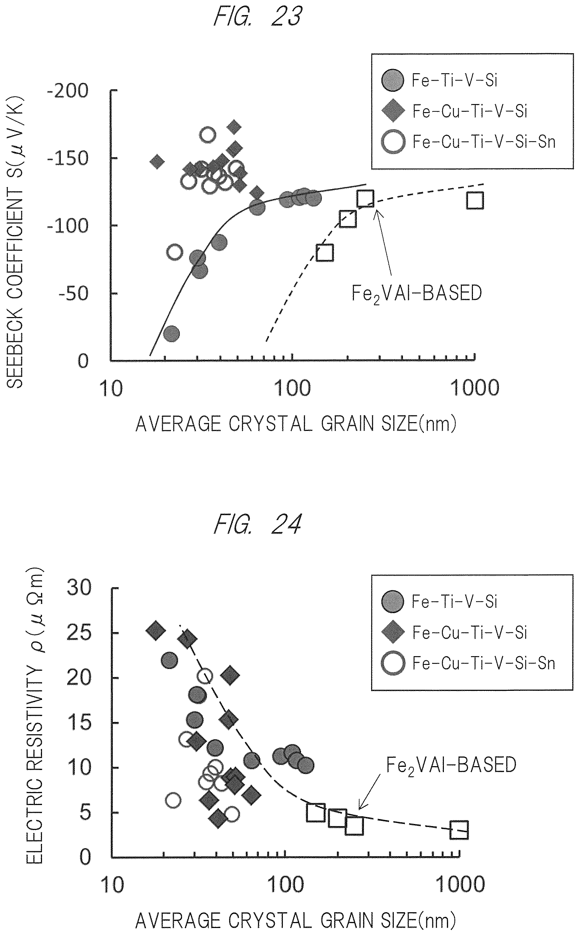

FIGs. 23 and 24 illustrate a relation between the Seebeck coefficient S and the average crystal grain size and between the electric resistivity $\rho$ and the average crystal grain size, respectively, which are obtained from Tables 1 to 5. FIG 23 is a graph illustrating the relation between the Seebeck coefficient S and the average crystal grain size. FIG 24 is a graph illustrating the relation between the electric resistivity $\rho$ and the average crystal grain size. A horizontal axis in each of FIG 23 and FIG 24 represents the average crystal grain size, a veitical axis in FIG 23 represents the Seebeck coefficient S, and a vertical axis in FIG. 24 represents the electric resistivity $\rho$.

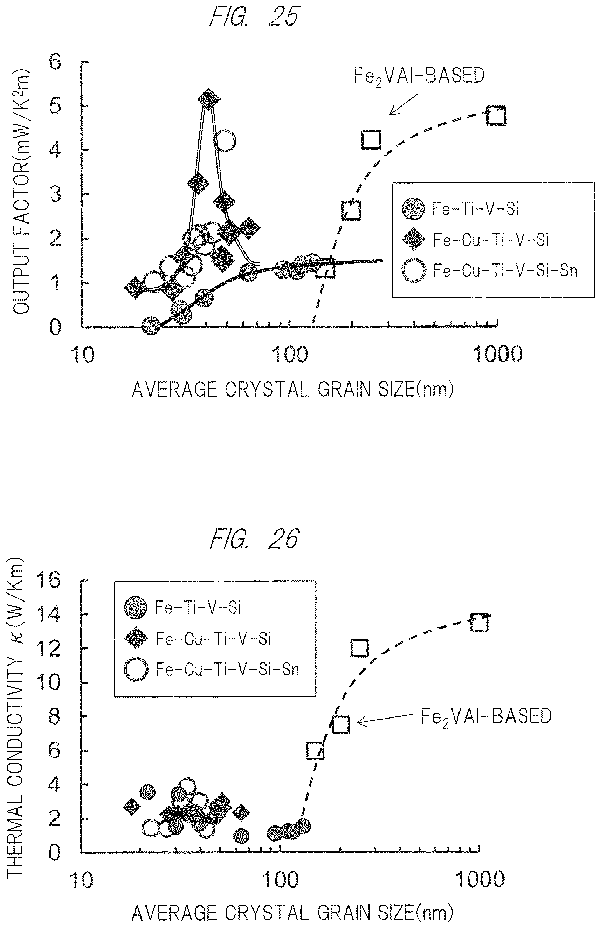

In the graphs of FIGs. 23 and 24, the results of Examples 1 to 8 are represented by 'Fe-Ti-V-Si," the results of Examples 9 to 18 are represented by "Fe-Cu-Ti-V-Si," the results of Examples 19 to 29 are represented by "Fe-Cu-Ti-V Si-Sn" (the same holds for FIGs. 25 to 27).

Note that FIGs. 23 and 24 show the Seebeck coefficient S and the electric resistivity $\rho$ of the $Fe_2VAl$-based full-Heusler alloy. The Seebeck coefficient S and the electric resistivity $\rho$ of the $Fe_2VAl$-based full-Heusler alloy having an average crystal grain size of greater than 200 nm are values read from data described in document, for example, "Materials Research Society Proceedings, Volume 1044 (2008 Material Research Society), 1044-U06-09." Further, although the document does not describe the Seebeck coefficient S and the electric resistivity $\rho$ of the $Fe_2VAl$-based full-Heusler alloy having an average crystal grain size of greater than 100 nm, they are estimated from a tendency of the data in the case of having an average crystal grain size of greater than 100 nm.

In FIGs. 23 and 24, for reference, dotted lines represent the Seebeck coefficient S and the electric resistivity $\rho$ of the $Fe_2VAl$-based full-Heusler alloy which have been measured in the same manner as described above.

Note that the Seebeck coefficient S and the electric resistivity $\rho$ of the $Fe_2VAl$-based full-Heusler alloy having an average crystal grain size of greater than 200 nm are values read from the data described in, for example, the document. Further, although the document does not describe the measurement vales in the case of having an average crystal grain size of 100 nm or more and less than 200 nm, the Seebeck coefficient S and the electric resistivity $\rho$ in the case where the average crystal grain size is in this range in FIGs. 23 and 24 are estimated from a tendency of the data in the case of having an average crystal grain size of greater than 200 nm.

As illustrated in FIG 23, it is clear that the Seebeck coefficient S of each of the thermoelectric conversion materials of Examples 1 to 29 (particularly Examples 9 to 29 in which Cu is added) is not decreased even when the crystal grain size is decreased until the average crystal grain size is decreased to substantially 200 nm or less, as different from the thermoelectric conversion material made of $Fe_2VAl$-based full-Heusler alloy.

Meanwhile, as illustrated in FIG 24, in the thermoelectric conversion materials of Examples 1 to 29, the electric resistivity $\rho$ is increased with a decrease of the average crystal grain size.

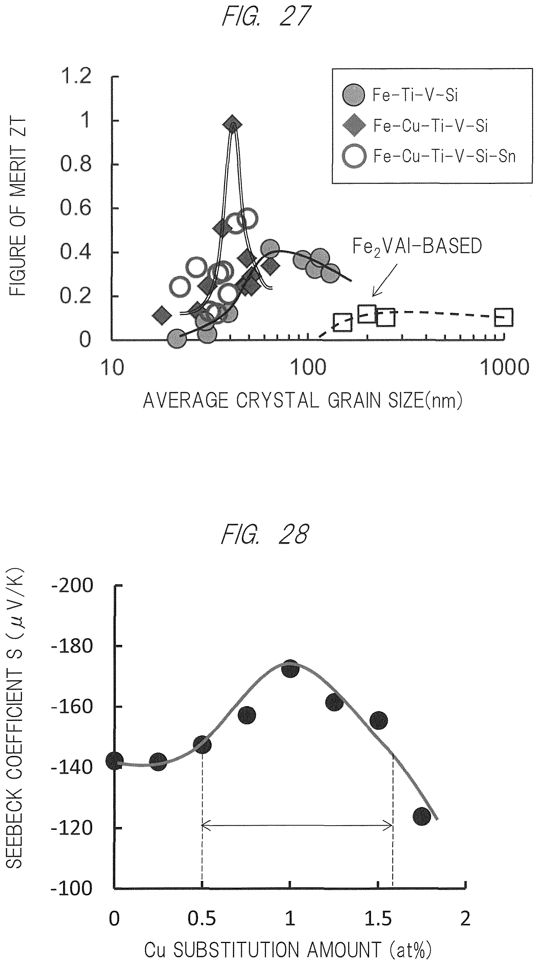

Subsequently, FIGs. 25 to 27 illustrate a relation between the output factor and the average crystal grain size, between the thermal conductivity $\kappa$ and the average crystal grain size, and between the figure of merit ZT and the average crystal grain size, respectively, which are obtained from Tables 1 to 5. FIG. 25 is a graph illustrating the relation between the output factor and the average crystal grain size. FIG 26 is a graph illustrating the relation between the thermal conductivity $\kappa$ and the average crystal grain size. FIG 27 is a graph illustrating the relation between the figure of merit ZT and the average crystal grain size.

As illustrated in FIG 25, it is clear that the output factor is not decreased even when the crystal grain is micronized until the average crystal grain size is decreased to substantially 200 nm or less, in the thermoelectric conversion materials of Examples 1 to 29, as different from the thermoelectric conversion material made of $Fe_2VAl$-based full-Heusler alloy. It is clear that, among them, the thermoelectric conversion materials of Examples 9 to 18, which are made of $Fe_2TiA$-based Full Heusler alloy after addition of Cu, i.e., after substitution by Cu, have an output factor as high as that of the thermoelectric conversion material made of $Fe_2VAl$-based full-Heusler alloy.

Further, as illustrated in FIG 26, it is clear that each of the thermoelectric conversion materials of Examples 1 to 29 has a smaller average crystal grain size than that of the thermoelectric conversion material made of $Fe_2VAl$-based full-Heusler alloy, whereby the thermal conductivity $\kappa$ is kept low.

Further, as illustrated in FIG 27, It is clear that the output factor of each of the thermoelectric conversion materials of Examples 1 to 29 is not decreased even when the crystal grain size is decreased until the average crystal grain size is decreased to substantially 200 nm or less, as compared to the thermoelectric conversion material made of $Fe_2VAl$-based full-Heusler alloy, whereby the figure of merit ZT is increased.

It is clear that, among them, each of the thermoelectric conversion materials of Examples 9 to 29, which are made of $Fe_2TiA$-based Full Heusler alloy after addition of Cu, i.e., after substitution by Cu, has a higher figure of merit ZT than that of each of the thermoelectric conversion materials of Examples 1 to 8, which are made of $Fe_2TiA$-based Full Heusler alloy without being substituted by Cu. Therefore, it is clear that, in order to obtain high thermoelectric conversion characteristics, addition of Cu is further preferred.

**EP 3 297 048 B1**

Subsequently, FIGs. 28 and 29 illustrate a relation between the Seebeck coefficient S and a Cu substitution amount, and between the figure of merit ZT and a V substitution amount, respectively, which are obtained from Tables 4 and 5. FIG. 28 is a graph illustrating the relation between the Seebeck coefficient S and the Cu substitution amount FIG. 29 is a graph illustrating the relation between the figure of merit ZT and the V substitution amount. As mentioned below, it has been found that, in the thermoelectric conversion material made of $Fe_2TiA$-based Full Heusler alloy which has been substituted by Cu, there is a strong correlation between the thermoelectric conversion characteristic of the Seebeck coefficient S and the Cu substitution amount. Also, it has been found that, in the thermoelectric conversion material made of $Fe_2TiA$-based Full Heusler alloy which has been substituted by V, there is a strong correlation between the thermoelectric conversion characteristic of the figure of merit ZT and the V substitution amount. Note that the Cu substitution amount is also the content of copper in the $Fe_2TiA$-based Full Heusler alloy. Further, the V substitution amount is also the content of vanadium in the $Fe_2TiA$-based Full Heusler alloy.

As illustrated in FIG 28, when the Cu substitution amount was greater than 0 at% and 1.75 at% or less, the absolute value of the Seebeck coefficient S became larger than 100 $\mu$V/K. Therefore, the content of copper in the $Fe_2TiA$-based Full Heusler alloy is preferably greater than 0 at% and 1.75 at% or less. Accordingly, it is possible to allow the absolute value of the Seebeck coefficient S of the $Fe_2TiA$-based Full Heusler alloy to be larger than 100 $\mu$V/K.

Further, as illustrated in FIG 28, when the Cu substitution amount was from 0.5 to 1.6 at%, the absolute value of the Seebeck coefficient S became larger than the case where the $Fe_2TiA$-based Full Heusler alloy is not substituted by Cu, i.e., the case where the Cu substitution amount is 0. Therefore, the content of Cu in the $Fe_2TiA$-based Full Heusler alloy is further preferably from 0.5 to 1.6 at%. Accordingly, it is possible to allow the absolute value of the Seebeck coefficient S of the $Fe_2TiA$-based Full Heusler alloy to be larger than that in the case where the $Fe_2TiA$-based Full Heusler alloy does not contain Cu.

Further, as illustrated in FIG. 29, when the V substitution amount was from 1.0 to 4.2 at%, the figure of merit ZT of the thermoelectric conversion material made of $Fe_2TiA$-based Full Heusler alloy became almost the same level as or greater than the figure of merit ZT of the thermoelectric conversion material made of $Fe_2VAl$-based full-Heusler alloy. Therefore, the content of V in the $Fe_2TiA$-based Full Heusler alloy is preferably from 1.0 to 4.2 at%. Accordingly, it is possible to allow the figure of merit ZT of the thermoelectric conversion material made of $Fe_2TiA$-based Full Heusler alloy to be almost the same level as or greater than the figure of merit ZT of the thermoelectric conversion material made of $Fe_2VAl$-based full-Heusler alloy. Note that, when the V substitution amount is from 1.0 to 4.2 at%, y in the composition formula (Chemical Formula 1) mentioned above satisfies the relation $y \leq 0.25$.

In the foregoing, the invention made by the inventors of the present invention has been concretely described based on the embodiment. However, it is needless to say that the present invention is not limited to the foregoing embodiment and various modifications and alterations can be made within the scope of the appended claims.

## EXPLANATION OF REFERENCE CHARACTERS

| | |
|---|---|
| 10 | thermoelectric conversion module |
| 11 | p-type thermoelectric conversion unit |
| 12 | n-type thermoelectric conversion unit |
| 13, 13a, 13b, 13c | electrodes |
| 14 | upper substrate |
| 15 | lower substrate |
| RG1, RG2, RG3 | region |

## Claims

**1.** A thermoelectric conversion material made of p-type or n-type full-Heusler alloy represented by a composition formula (Chemical Formula 1) below:

$$(Fe_{1-x}M1_x)_{2+\sigma}(Ti_{1-y}M2_y)_{1+\varphi}(A_{1-z}M3_z)_{1+\omega} \ldots \qquad \text{(Chemical Formula 1),}$$

**characterized in that** the A is Si
the M1 is Cu and the M2 is V,
the M3 is Sn,
when the $\sigma$, the $\varphi$, and the $\omega$ satisfy a relation $\sigma + \varphi + \omega = 0$, and
the x, the y, and the z satisfy relations $x = 0$, $y = 0$, and $z = 0$, respectively, contents of Fe, Ti, and A in the alloy represented by the composition formula (Chemical Formula 1) are u at%, v at%, and w at%, respectively, and when a composition of the alloy in a ternary phase diagram of Fe-Ti-A is represented by a point (u, v, w), the point (u, v, w) is located in a region inside a hexagon having points (50, 37, 13), (45, 30, 25), (39.5, 25, 35.5), (50,14,36), (54, 21, 25), and (55.5, 25,19.5) as apexes in the ternary phase diagram,

when a valence electron number of the M1 is m1,

a valence electron number of the M2 is m2, and

a valence electron number of the M3 is m3,

an average valence electron number per atom VEC in the full-Heusler alloy is represented by a mathematical formula (Mathematical Formula 1) below:

$$\text{VEC}\,(\sigma, x, \varphi, y, \omega, z) = [\{8 \times (1 - x) + m1 \times x\} \times (2 + \sigma) + \{4 \times (1 - y) + m2 \times y\} \times (1 + \varphi) + \{4 \times (1 - z) + m3 \times z\} \times (1 + \omega)]/4 \dots \text{(Mathematical Formula 1)}$$

as a function of the $\sigma$, the x, the $\varphi$, the y, the $\omega$, and the z, and

$\Delta$VEC represented by a mathematical formula (Mathematical Formula 2) below:

$$\Delta\text{VEC} = \text{VEC}\,(\sigma, x, \varphi, y, \omega, z) - \text{VEC}\,(\sigma, 0, \varphi, 0, \omega, 0) \dots \text{(Mathematical Formula 2)}$$

satisfies a relation $0 < |\Delta\text{VEC}| \leq 0.2$, or satisfies a relation $0.2 < |\Delta\text{VEC}| \leq 0.3$;

the thermoelectric conversion material **characterized in that**:

the full-Heusler alloy contains Cu and V,

a content of V in the full-Heusler alloy is 1.0 at% or more and 4.2 at% or less;

wherein the content of Cu in the full-Heusler alloy is 0.5 at% or more and 1.6 at% or less; and

wherein the full-Heusler alloy has an average crystal grain size of 30 nm or more and 500 nm or less, measured according to the description;

wherein the y satisfies a relation $y \leq 0.25$ and

wherein $\sigma$ satisfies the relation $-0.36 \leq \sigma \leq -0.04$ if Si is increased by 1 to 9 at% and Fe is decreased by 1 to 9 at% compared to the stoichiometric composition $\sigma + \varphi + \omega = 0$; or

wherein $\sigma$ satisfies the relation $-0.32 \leq \sigma \leq -0.08$ if Fe is decreased by 2 to 8 at% and Fe is decreased by 2 to 8 at% compared to the stoichiometric composition $\sigma + \varphi + \omega = 0$; or

wherein $\varphi$ satisfies the relation $0.04 \leq \varphi \leq 0.32$ if Si is decreased by 1 to 8 at% and Ti is increased by 1 to 8 at% compared to the stoichiometric composition $\sigma + \varphi + \omega = 0$.

2. The thermoelectric conversion material made of p-type or n-type full-Heusler alloy according to claim 1, represented by a composition formula (Chemical Formula 2) below:

$$(\text{Fe}_{1-x}\text{Cu}_x)_{2+\sigma}(\text{Ti}_{1-y}\text{V}_y)_{1+\varphi}\text{A}_{1+\omega\dots} \qquad \text{(Chemical Formula 2)},$$

**characterized in that**:

an average valence electron number per atom VEC in the full-Heusler alloy is represented by a mathematical formula (Mathematical Formula 3) below:

$$\text{VEC}\,(\sigma, x, \varphi, y, \omega) = [\{8 \times (1 - x) + 11 \times x\} \times (2 + \sigma) + \{4 \times (1 - y) + 5 \times y\} \times (1 + \varphi) + 4 \times (1 + \omega)]/4 \dots \text{(Mathematical Formula 3)}$$

as a function of the $\sigma$, the x, the $\varphi$, the y, and the $\omega$, and

$\Delta$VEC represented by a mathematical formula (Mathematical Formula 4) below:

$$\Delta\text{VEC} = \text{VEC}\,(\sigma, x, \varphi, y, \omega) - \text{VEC}\,(\sigma, 0, \varphi, 0, \omega) \dots \text{(Mathematical Formula 4)}$$

satisfies the relation $0 < |\Delta\text{VEC}| \leq 0.2$ or satisfies the relation $0.2 < |\Delta\text{VEC}| \leq 0.3$.

**Patentansprüche**

1.  Material zur thermoelektrischen Umsetzung, das aus einer vollständigen Heusler-Legierung des p-Typs oder des n-Typs hergestellt ist, das durch eine Zusammensetzungsformel (chemische Formel 1) wie im Folgenden dargestellt wird:

$$(Fe_{1-x}M1_x)_{2+\sigma}(Ti_{1-y}M2_y)_{1+\varphi}(A_{1-z}M3_z)_{1+\omega} \qquad \text{(chemische Formel 1)}$$

    **dadurch gekennzeichnet, dass**:

    A gleich Si ist,
    M1 gleich Cu ist und M2 gleich V ist,
    M3 gleich Sn ist,
    wenn $\sigma$, $\phi$ und $\omega$ eine Relation $\sigma + \varphi + \omega = 0$ erfüllen, und
    x, y und z die Relationen $x = 0$, $y = 0$ bzw. $z = 0$ erfüllen,
    der Gehalt von Fe, Ti und A in der Legierung, die durch die Zusammensetzungsformel (chemische Formel 1) dargestellt wird, u Atom-% bzw. v Atom-% bzw. w Atom-% beträgt und
    wenn eine Zusammensetzung der Legierung in einem Dreifach-Phasendiagramm von Fe-Ti-A durch einen Punkt (u, v, w) dargestellt wird, der Punkt (u, v, w) in einem Bereich im Inneren eines Hexagons angeordnet ist, das die Punkte (50, 37, 13), (45, 30, 25), (39,5, 25, 35,5), (50, 14, 36), (54, 21, 25) und (55,5, 25, 19,5) als Scheitelpunkte in dem Dreifach-Phasendiagramm aufweist, wenn eine Anzahl der Valenzelektronen von M1 gleich m1 ist,
    eine Anzahl der Valenzelektronen von M2 gleich m2 ist und
    eine Anzahl der Valenzelektronen von M3 gleich m3 ist,
    eine durchschnittliche Anzahl der Valenzelektronen pro Atom VEC in der vollständigen Heusler-Legierung durch eine mathematische Formel (mathematische Formel 1) wie im Folgenden als eine Funktion von $\sigma$, x, $\varphi$, y, $\omega$ und z dargestellt wird:

$$VEC(\sigma, x, \varphi, y, \omega, z) = [\{8 \times (1 - x) + m1 \times x\} \times (2 + \sigma) +$$

$$\{4 \times (1 - y) + m2 \times y\} \times (1 + \varphi) + \{4 \times (1 - z) + m3 \times z\} \times (1 + \omega)]/4$$

$$\text{(mathematische Formel 1),}$$

    und
    $\Delta$VEC, das durch eine mathematische Formel (mathematische Formel 2) wie im Folgenden dargestellt wird:

$$\Delta VEC = VEC(\sigma, x, \varphi, y, \omega, z) - VEC(\sigma, 0, \varphi, 0, \omega, 0)$$

$$\text{(mathematische Formel 2),}$$

    eine Relation $0 < \Delta VEC \leq 0{,}2$ erfüllt oder eine Relation $0{,}2 < |\Delta VEC| \leq 0{,}3$ erfüllt;
    wobei das Material zur thermoelektrischen Umsetzung, **dadurch gekennzeichnet ist, dass**:

    die vollständige Heusler-Legierung Cu und V enthält,
    ein Gehalt von V in der vollständigen Heusler-Legierung 1,0 Atom-% oder mehr und 4,2 Atom-% oder weniger beträgt;
    wobei der Gehalt von Cu in der vollständigen Heusler-Legierung 0,5 Atom-% oder mehr und 1,6 Atom-% oder weniger beträgt; und
    wobei die vollständige Heusler-Legierung eine durchschnittliche Kristallkorngröße von 30 nm oder mehr und 500 nm oder weniger, gemessen gemäß der Beschreibung, aufweist;
    wobei y eine Relation $y \leq 0{,}25$ erfüllt; und
    wobei $\sigma$ die Relation $-0{,}36 \leq \sigma \leq 0{,}04$ erfüllt, wenn verglichen mit der stöchiometrischen Zusammensetzung $\sigma + \varphi + \omega = 0$ Si um 1 bis 9 Atom-% erhöht wird und Fe um 1 bis 9 Atom-% vermindert wird; oder
    wobei $\sigma$ die Relation $-0{,}32 \leq \sigma \leq 0{,}08$ erfüllt, wenn verglichen mit der stöchiometrischen Zusammensetzung $\sigma + \varphi + \omega = 0$ Fe um 2 bis 8 Atom-% vermindert wird und Fe um 2 bis 8 Atom-% vermindert wird; oder
    wobei $\varphi$ die Relation $0{,}04 \leq \varphi \leq 0{,}32$ erfüllt, wenn verglichen mit der stöchiometrischen Zusammensetzung

$\sigma + \phi + \omega = 0$ Si um 1 bis 8 Atom-% vermindert wird und Ti um 1 bis 8 Atom-% erhöht wird.

2. Material zur thermoelektrischen Umsetzung, das aus einer vollständigen Heusler-Legierung des p-Typs oder des n-Typs hergestellt ist, nach Anspruch 1, das durch eine Zusammensetzungsformel (chemische Formel 2) wie im Folgenden dargestellt wird:

$$(Fe_{1-x}Cu_x)_{2+\sigma}(Ti_{1-y}V_y)_{1+\varphi}A_{1+\omega} \qquad \text{(chemische Formel 2)},$$

**dadurch gekennzeichnet, dass**:

eine durchschnittliche Anzahl der Valenzelektronen pro Atom VEC in der vollständigen Heusler-Legierung durch eine mathematische Formel (mathematische Formel 3) wie im Folgenden als eine Funktion von $\sigma$, x, $\varphi$, y und $\omega$ dargestellt wird:

$$VEC(\sigma, x, \varphi, y, \omega) = [\{8 \times (1 - x) + 11 \times x\} \times (2 + \sigma) +$$
$$\{4 \times (1 - y) + 5 \times y\} \times (1 + \varphi) + 4 \times (1 + \omega)]/4$$
$$\text{(mathematische Formel 3)},$$

und
$\Delta VEC$, das durch eine mathematische Formel (mathematische Formel 4) wie im Folgenden dargestellt wird:

$$\Delta VEC = VEC(\sigma, x, \varphi, y, \omega) - VEC(\sigma, O, \varphi, O, \omega)$$
$$\text{(mathematische Formel 4)},$$

die Relation $0 < |\Delta VEC| \leq 0,2$ erfüllt oder die Relation $0,2 < |\Delta VEC| \leq 0,3$ erfüllt.

## Revendications

1. Matériau de conversion thermoélectrique fait d'un alliage Heusler entier du type p ou du type n représenté par une formule de composition (formule chimique 1) ci-dessous :

$$(Fe_{1-x}M1_x)_2 + \sigma (Ti_{1-y}M2_y)1 + \phi (A_{1-z}M3_z)1 + \omega \ldots \qquad \text{(Formule chimique 1)}$$

**caractérisé en ce que** A est Si

M1 est Cu et M2 est V,
M3 est Sn,
quand $\sigma$, $\phi$ et $\omega$ satisfont une relation $\sigma + \varphi + \omega = 0$, et
x, y et z satisfont les relations x=0, x=0, et z=0, respectivement, les teneurs de Fe, Ti et A dans l'alliage représenté par la formule de composition (formule chimique 1) sont u at%, v at% et w at%, respectivement, et
quand une composition de l'alliage dans un diagramme de phase ternaire de Fe-Ti-A est représentée par un point (u, v, w), le
le point (u, v, w) est situé dans une région à l'intérieur d'un hexagone ayant les points (50, 37, 13), (45, 30, 25), (39.5, 25, 35.5), (50, 14, 36), (54, 21, 25), et (55.5, 25, 19.5) comme sommets dans le diagramme de phase ternaire,
quand un nombre d'électrons de valence de M1 est m1, un nombre d'électrons de valence de M2 est m2, et un nombre d'électrons de valence de M3 est m3, un nombre d'électrons de valence moyen par atome VEC dans l'alliage Heusler entier est représenté par une formule mathématique (formule mathématique 1) ci-dessous :

$$VEC (\sigma, x, \varphi, y, \omega, z) = [ \{8 \times (1-x) + m1 \times x\} \times (2+\sigma) + \{4 \times (1-y) + m2 \times y\} \times (1+\varphi) + \{4 \times (1-z) + m3 \times z\} \times (1+\omega)/4 \ldots \text{formule mathématique 1}$$

en tant que fonction de σ, x, φ, y, ω et z, et
ΔVEC représenté par une formule mathématique (Formule mathématique 2) ci-dessous :

$$\Delta VEC = VEC\ (\sigma,\ x,\ \varphi,\ y,\ \omega,\ z)\ -\ VEC\ (\sigma,\ 0,\ \varphi,\ 0,\ \omega,\ 0)\ ...\ \text{(Formule mathématique 2)}$$

satisfait une relation $0 < |\Delta VEC| \le 0,2$, ou
satisfait une relation $0,2 < |\Delta VEC| \le 0,3$ ;
le matériau de conversion thermoélectrique étant **caractérisé en ce que** :

l'alliage Heusler entier contient Cu et V,
une teneur de V dans l'alliage Heusler entier est 1,0 at% ou plus et 4,2 at% ou moins ;
dans lequel la teneur de Cu dans l'alliage Heusler entier est 0,5 at% ou plus et 1,6 at% ou moins ; et
dans lequel l'alliage Heusler entier présente une taille de grains de cristal moyenne de 30 nm ou plus et 500 nm ou moins, mesurée en accord avec la description :

dans lequel y satisfait une relation $y \le 0,25$ et
dans lequel σ satisfait la relation $-0,36 \le \sigma \le -0,04$ si Si est augmenté de 1 à 9 at% et Fe est diminué de 1 à 9 at% par comparaison à la composition stœchiométrique $\sigma + \phi + \omega = 0$ ; ou
dans lequel σ satisfait la relation $-0,32 \le \sigma \le -0,08$ si Fe est diminué de 2 à 8 at% et Fe est diminué de 2 à 8 at% par comparaison à la composition stoechiométrique $\sigma + \phi + \omega = 0$ ; ou
dans lequel φ satisfait la relation $0,04 \le \phi \le 0,32$ si Si est diminué de 1 à 8 at% et Ti est augmenté de 1 à 8 at% par comparaison à la composition stœchiométrique $\sigma + \phi + \omega = 0$.

2. Matériau de conversion thermoélectrique fait d'un alliage Heusler entier de type p ou de type n selon la revendication 1, représenté par une formule de composition (Formule chimique 2) ci-dessous :

$$(Fe_{1-x}Cu_x)_{2+\sigma}(Ti_{1-y}V_y)_{1+\varphi}A_{1+w} \qquad \text{(Formule chimique 2)},$$

**caractérisé en ce que** :

un nombre d'électrons de valence moyen par atome VEC dans l'alliage Heusler entier est représenté par une formule mathématique (Formule mathématique 3) ci-dessous :

$$VEC\ (\sigma,\ x,\ \varphi,\ y,\ \omega) = [\{8\ ^x\ (1\text{-}x) + 11\ ^x\ x\}\ ^x\ (2+\sigma) + \{4\ ^x\ (1\text{-}y) + 5\ ^x\ y\}\ x\ (1+\varphi) + 4\ ^x\ (1+\omega)]/4\ ...\ \text{(Formule mathématique 3)}$$

en tant que fonction de σ, x, φ, y et ω, et
ΔVEC représenté par une formule mathématique (Formule mathématique 4) ci-dessous :

$$\Delta VEC = VEC\ (\sigma,\ x,\ \varphi,\ y,\ \omega)\ -\ VEC\ (\sigma,\ 0,\ \varphi,\ 0,\ \omega)\ ...\ \text{(Formule mathématique 4)}$$

satisfait la relation $0 < |\Delta VEC| \le 0,2$ ou satisfait la relation $0,2 < |\Delta VEC| \le 0,3$.

*FIG. 1*

*FIG. 2*

FIG. 3

FIG. 4

*FIG. 5*

*FIG. 6*

*FIG. 7*

*FIG. 8*

FIG. 9

FIG. 10

FIG. 11

*FIG. 12*

*FIG. 13*

*FIG. 14*

*FIG. 15*

*FIG. 16*

*FIG. 17*

FIG. 18

FIG. 19

FIG. 20

## FIG. 21

## FIG. 22

*FIG. 23*

*FIG. 24*

*FIG. 25*

*FIG. 26*

## FIG. 27

## FIG. 28

FIG. 29

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2013093967 A
- JP 2013102002 A
- JP 2013149878 A
- EP 2854189 A1
- US 2014345663 A1
- JP 2008021982 A

### Non-patent literature cited in the description

- Fe-Si-Ti (Iron-Silicon-Titanium). **RAGHAVAN V.** Journal of Phase Equilibria and Diffusion. Springer, 01 January 2009, vol. 30, 393-396
- Materials Research Society Proceedings. Material Research Society, 2008, vol. 1044